(19) Europäisches Patentamt
European Patent Office
Office européen des brevets

(11) **EP 4 068 384 A1**

(12) **EUROPEAN PATENT APPLICATION**
published in accordance with Art. 153(4) EPC

(43) Date of publication:
**05.10.2022 Bulletin 2022/40**

(21) Application number: **21830053.1**

(22) Date of filing: **17.05.2021**

(51) International Patent Classification (IPC):
***H01L 27/32*** *(2006.01)*

(52) Cooperative Patent Classification (CPC):
**H01L 27/32; H01L 51/52**

(86) International application number:
**PCT/CN2021/094030**

(87) International publication number:
**WO 2021/258910 (30.12.2021 Gazette 2021/52)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **23.06.2020 CN 202010580274**

(71) Applicants:
• **BOE Technology Group Co., Ltd.
Beijing 100015 (CN)**
• **Chengdu BOE Optoelectronics Technology Co.,
Ltd.
Chengdu, Sichuan 611731 (CN)**

(72) Inventors:
• **WU, Chao
Beijing 100176 (CN)**
• **LONG, Yue
Beijing 100176 (CN)**
• **WEI, Feng
Beijing 100176 (CN)**
• **LIU, Cong
Beijing 100176 (CN)**

(74) Representative: **Brötz, Helmut et al
Rieder & Partner mbB
Patentanwälte - Rechtsanwalt
Yale-Allee 26
42329 Wuppertal (DE)**

(54) **DISPLAY SUBSTRATE AND DISPLAY APPARATUS**

(57) A display substrate and a display apparatus. The display substrate (01) comprises a display area (10). The display area (10) comprises a first display area (11), a second display area (12), and a first connection line (110). The first display area (11) comprises a first light-emitting element (411). The second display area (12) comprises a first pixel circuit (412). The first connection line (110) is electrically connected to a first sub-pixel circuit (412a) and an anode of a first sub-light-emitting element (411a). The first connection line (110) is located at a first connection layer (21), and the anode of the first sub-light-emitting element (411a) is electrically connected to the first connection line (110) by means of a first via hole (HI) that penetrates a first insulating layer (31) and a second insulating layer (32). The cross-sectional shape of the first via hole (HI) in a plane perpendicular to the display substrate (01) is an inverted boss shape, and in the first via hole (HI), the opening aperture of the second insulating layer (32) is greater than an opening aperture of the first insulating layer (31). The anode of the first sub-light-emitting element (411a) comprises a first groove structure (GR1) located in the first via hole (HI), wherein the bottom of the first groove structure (GR1) is in contact with the first connection line (110), so as to realize electrical connection. According to the display substrate (01), the processing difficulty can be reduced, and the reliability of electrical connection and the uniformity of transmitted light are improved.

FIG. 6A

## Description

The present application claims priority of Chinese Patent Application No. 202010580274.8, filed on June 23, 2020, and the entire content disclosed by the Chinese patent application is incorporated herein by reference as part of the present application.

## TECHNICAL FIELD

Embodiments of the present disclosure relate to a display substrate and a display device.

## BACKGROUND

Organic light-emitting diode (OLED) display elements have the characteristics such as wide viewing angle, high contrast ratio, fast response speed, wide color gamut, high screen-to-body ratio, self-illumination, thinness and lightweight, and so on. Due to the above characteristics and advantages, the organic light-emitting diode (OLED) display element has gradually attracted widespread attention and can be applied to devices with a display function, such as mobile phones, monitors, notebook computers, smart watches, digital cameras, instrumentation, flexible wearable devices, and the like. With the further development of the display technology, the display device with a high screen-to-body ratio no longer meets people's needs, and display devices with a full screen become the development trend of the display technology in the future.

## SUMMARY

At least one embodiment of the present disclosure provides a display substrate, which comprises a display region. The display region comprises a first display region and a second display region that do not overlap with each other, the second display region at least partially surrounds the first display region, and light transmittance of the first display region is greater than light transmittance of the second display region; the first display region comprises at least one first light-emitting element, and the second display region comprises at least one first pixel circuit; the display region further comprises at least one first connection line, and the first connection line comprises a first end located in the first display region and a second end located in the second display region; the at least one first light-emitting element comprises a first light-emitting sub-element, and the at least one first pixel circuit comprises a first pixel sub-circuit, the first end of the first connection line is electrically connected to an anode of the first light-emitting sub-element, and the second end of the first connection line is electrically connected to the first pixel sub-circuit; the display substrate comprises a first connection layer, a first insulation layer, a second insulation layer, and an anode layer that are stacked in sequence; the first connection line is in the first connection layer, the anode of the first light-emitting sub-element is in the anode layer, and the anode of the first light-emitting sub-element is electrically connected to the first connection line through a first hole penetrating the first insulation layer and the second insulation layer; a shape of a cross section of the first hole in a plane perpendicular to the display substrate is an inverted convex shape, and in the first hole, a diameter of an opening of the second insulation layer is larger than a diameter of an opening of the first insulation layer; and the anode of the first light-emitting sub-element comprises a first groove structure, the first groove structure is in the first hole, and a bottom of the first groove structure is in contact with the first connection line for realizing electrical connection.

For example, in the display substrate provided by an embodiment of the present disclosure, the display region further comprises at least one second connection line, and the second connection line comprises a first end located in the first display region and a second end located in the second display region; the at least one first light-emitting element further comprises a second light-emitting sub-element, the at least one first pixel circuit further comprises a second pixel sub-circuit, the first end of the second connection line is electrically connected to an anode of the second light-emitting sub-element, and the second end of the second connection line is electrically connected to the second pixel sub-circuit; the display substrate further comprises a second connection layer, the second connection layer is between the first insulation layer and the second insulation layer, and the second connection line is in the second connection layer; the anode of the second light-emitting sub-element is in the anode layer, and the anode of the second light-emitting sub-element is electrically connected to the second connection line through a second hole penetrating the second insulation layer; and the anode of the second light-emitting sub-element comprises a second groove structure, the second groove structure is in the second hole, and a bottom of the second groove structure is in contact with the second connection line for realizing electrical connection.

For example, in the display substrate provided by an embodiment of the present disclosure, a surface of the first groove structure away from the first connection layer is a curved surface, and a surface of the second groove structure away from the second connection layer is a curved surface.

For example, in the display substrate provided by an embodiment of the present disclosure, each of the first pixel sub-circuit and the second pixel sub-circuit comprises a first switch transistor, and the first switch transistor comprises a gate electrode, a first electrode, and a second electrode; the display substrate further comprises a source-drain metal layer and a third insulation layer, the third insulation layer is on the source-drain metal layer, the first connection layer is on the third insulation layer, and the first electrode of the first switch transistor and the second electrode of the first switch transistor are in the source-drain metal layer; the second end of the first connection line is electrically connected to the first electrode or the second electrode of the first switch transistor of the first pixel sub-circuit through a third hole penetrating the third insulation layer; and the second end of the second connection line is electrically connected to the first electrode or the second electrode of the first switch transistor of the second pixel sub-circuit through a fourth hole penetrating the third insulation layer and the first insulation layer.

For example, in the display substrate provided by an embodiment of the present disclosure, a shape of a cross section of the fourth hole in the plane perpendicular to the display substrate is an inverted convex shape, and in the fourth hole, a diameter of an opening of the first insulation layer is larger than a diameter of an opening of the third insulation layer.

For example, in the display substrate provided by an embodiment of the present disclosure, in the fourth hole, the second connection line is electrically connected to a transition metal layer, the transition metal layer is in contact with and is electrically connected to the first electrode or the second electrode of the first switch transistor of the second pixel sub-circuit, and the transition metal layer and the first connection layer are formed in a same process.

For example, in the display substrate provided by an embodiment of the present disclosure, the second display region further comprises at least one second light-emitting element and at least one second pixel circuit, and the second light-emitting element is electrically connected to the second pixel circuit; the second pixel circuit comprises a second switch transistor, the second switch transistor comprises a gate electrode, a first electrode, and a second electrode, and the first electrode of the second switch transistor and the second electrode of the second switch transistor are in the source-drain metal layer; an anode of the second light-emitting element is in the anode layer, and the anode of the second light-emitting element is electrically connected to the first electrode or the second electrode of the second switch transistor through a fifth hole penetrating the first insulation layer, the second insulation layer, and the third insulation layer; and a shape of a cross section of the fifth hole in the plane perpendicular to the display substrate is an inverted convex shape, and in the fifth hole, a diameter of an opening of the first insulation layer is larger than a diameter of an opening of the third insulation layer.

For example, in the display substrate provided by an embodiment of the present disclosure, in the fifth hole, a diameter of an opening of the second insulation layer is equal to or larger than the diameter of the opening of the first insulation layer.

For example, in the display substrate provided by an embodiment of the present disclosure, the anode of the second light-emitting element comprises a third groove structure, the third groove structure is in the fifth hole, and a bottom of the third groove structure is in contact with the first electrode or the second electrode of the second switch transistor for realizing electrical connection.

For example, in the display substrate provided by an embodiment of the present disclosure, the display region further comprises a third display region, the third display region at least partially surrounds the second display region, and the third display region does not overlap with the first display region and the second display region; the third display region comprises at least one third light-emitting element and at least one third pixel circuit, and the third light-emitting element is electrically connected to the third pixel circuit; the third pixel circuit comprises a third switch transistor, the third switch transistor comprises a gate electrode, a first electrode, and a second electrode, and the first electrode of the third switch transistor and the second electrode of the third switch transistor are in the source-drain metal layer; an anode of the third light-emitting element is in the anode layer, and the anode of the third light-emitting element is electrically connected to the first electrode or the second electrode of the third switch transistor through a sixth hole penetrating the first insulation layer, the second insulation layer, and the third insulation layer; and a shape of a cross section of the sixth hole in the plane perpendicular to the display substrate is an inverted convex shape, and in the sixth hole, a diameter of an opening of the first insulation layer is larger than a diameter of an opening of the third insulation layer.

For example, in the display substrate provided by an embodiment of the present disclosure, in the sixth hole, a diameter of an opening of the second insulation layer is equal to or larger than the diameter of the opening of the first insulation layer.

For example, in the display substrate provided by an embodiment of the present disclosure, the anode of the third light-emitting element comprises a fourth groove structure, the fourth groove structure is in the sixth hole, and a bottom of the fourth groove structure is in contact with the first electrode or the second electrode of the third switch transistor for realizing electrical connection.

For example, in the display substrate provided by an embodiment of the present disclosure, the first connection line and the second connection line each comprises a transparent conductive wiring.

For example, in the display substrate provided by an embodiment of the present disclosure, the at least one first light-emitting element comprises a plurality of first light-emitting elements, the plurality of first light-emitting elements are arranged in an array, and both the first connection line and the second connection line extend along a row direction of the array formed by the plurality of first light-emitting elements.

For example, in the display substrate provided by an embodiment of the present disclosure, each of the first light-emitting element, the second light-emitting element, and the third light-emitting element comprises an organic light-emitting diode.

For example, in the display substrate provided by an embodiment of the present disclosure, the at least one first light-emitting element comprises a plurality of first light-emitting elements, the at least one second light-emitting element comprises a plurality of second light-emitting elements, and the at least one third light-emitting element comprises a plurality of third light-emitting elements; and a distribution density per unit area of the plurality of first light-emitting elements in the first display region is smaller than or equal to a distribution density per unit area of the plurality of second light-emitting elements in the second display region, and the distribution density per unit area of the plurality of second light-emitting elements in the second display region is smaller than a distribution density per unit area of the plurality of third light-emitting elements in the third display region.

At least one embodiment of the present disclosure further provides a display device, which comprises the display substrate provided by any embodiment of the present disclosure.

For example, the display device provided by an embodiment of the present disclosure further comprises a sensor. The display substrate has a first side for display and a second side opposite to the first side, and the first display region allows light from the first side to be at least partially transmitted to the second side, the sensor is on the second side of the display substrate, and the sensor is configured to receive light from the first side.

For example, in the display device provided by an embodiment of the present disclosure, an orthographic projection of the sensor on the display substrate at least partially overlaps the first display region.

BRIEF DESCRIPTION OF THE DRAWINGS

In order to clearly illustrate the technical solutions of the embodiments of the present disclosure, the drawings of the embodiments will be briefly described in the following; it is obvious that the described drawings are only related to some embodiments of the present disclosure and thus are not limitative to the present disclosure.

FIG. 1 is a schematic plane view of a display substrate provided by at least one embodiment of the present disclosure;
FIG. 2 is a schematic plane view of a first display region and a second display region of the display substrate illustrated in FIG. 1;
FIG. 3 is an example of the first display region and the second display region, illustrated in FIG. 2, of the display substrate;
FIG. 4 is an enlarged view of a partial region REG1 in FIG. 3;
FIG. 5A is an enlarged view of a partial region REG2 in FIG. 3;

FIG. 5B is an enlarged view of a region in FIG. 5A including only one column of first pixel circuits, one column of first light-emitting elements, one column of second pixel circuits, and one column of second light-emitting elements;
FIG. 6A is a schematic view of a cross section along a line A-A' in FIG. 5B;
FIG. 6B is an enlarged view of a first hole H1 in FIG. 6A;
FIG. 6C is a schematic layout diagram of a region corresponding to the first hole H1 and a connected anode in FIG. 6A;
FIG. 6D is a schematic layout diagram of a region corresponding to a third hole H3 and a connected source-drain metal layer in FIG. 6A;
FIG. 7A is a schematic view of a cross section along a line B-B' in FIG. 5B;
FIG. 7B is an enlarged view of a second hole H2 in FIG. 7A;
FIG. 7C is a schematic layout diagram of a region corresponding to the second hole H2 and a connected anode in FIG. 7A;
FIG. 7D is another schematic structural diagram of a fourth hole H4;
FIG. 7E is a schematic layout diagram of a region corresponding to the fourth hole H4 and a connected source-drain metal layer in FIG. 7A;
FIG. 8A is a schematic view of a cross section along a line C-C' in FIG. 5B;
FIG. 8B is an enlarged view of a fifth hole H5 in FIG. 8A;
FIG. 8C is a schematic layout diagram of a region corresponding to the fifth hole H5 and a connected anode and a connected source-drain metal layer in FIG. 8A;
FIG. 9 is an enlarged view of a partial region REG3 of a third display region of the display substrate illustrated in FIG. 1;
FIG. 10A is a schematic view of a cross section along a line D-D' in FIG. 9;
FIG. 10B is an enlarged view of a sixth hole H6 in FIG. 10A;
FIG. 11A is a schematic layout diagram corresponding to a partial region REG4 in FIG. 4;
FIG. 11B is a schematic layout diagram illustrating only a first connection line in FIG. 11A;
FIG. 11C is a schematic layout diagram illustrating only a second connection line in FIG. 11A;
FIG. 11D is a schematic view of a cross section along a line E-E' in FIG. 11A;
FIG. 12A is a first schematic layout diagram corresponding to a second light-emitting element in a second display region of a display substrate provided by some embodiments of the present disclosure;
FIG. 12B is a second schematic layout diagram corresponding to a second light-emitting element in a second display region of a display substrate provided by some embodiments of the present disclosure;

FIG. 13A is a schematic structural diagram of a 7T1C pixel circuit;
FIG. 13B is a driving timing diagram of the 7T1C pixel circuit illustrated in FIG. 13A;
FIG. 14 is a schematic block diagram of a display device provided by at least one embodiment of the present disclosure; and
FIG. 15 is a schematic diagram of a stacked structure of a display device provided by at least one embodiment of the present disclosure.

DETAILED DESCRIPTION

In order to make objects, technical solutions, and advantages of the embodiments of the present disclosure apparent, the technical solutions of the embodiments of the present disclosure will be described in a clearly and fully understandable way in connection with the drawings related to the embodiments of the present disclosure. Apparently, the described embodiments are just a part but not all of the embodiments of the present disclosure. Based on the described embodiments of the present disclosure, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

For the current display substrate having a under-screen sensor (e.g., a camera), in order to improve the transmittance of the display substrate corresponding to the display region of the under-screen sensor (camera), a distribution density per unit area (PPI) of the light-emitting elements in the display region corresponding to the under-screen sensor (camera) may be smaller than a distribution density per unit area of the light-emitting elements in other display regions of the display substrate.

However, due to the different distribution densities per unit area of light-emitting elements in different regions on the display substrate, the arrangement modes of light-emitting elements and corresponding pixel circuits in different regions are different, so that the wiring manner and the layout design of the display substrate are different from those of a common display substrate having light-emitting elements uniformly distributed. As a result, more holes need to be provided on the display substrate to achieve electrical connection between the film layers. When adopting the usual arrangement of holes, the presence of many holes on the display substrate affects the stability of electrical connection and makes the uniformity of transmitted light poor, thereby affecting the sensing effect of the under-screen sensor (such as a camera), and reducing the performance of the display device adopting the display substrate.

At least one embodiment of the present disclosure provides a display substrate and a display device. The display substrate can reduce the processing difficulty, improve the reliability of the electrical connection, improve the uniformity of transmitted light, and help to improve the sensing effect of the under-screen sensor (such as a camera).

Hereinafter, embodiments of the present disclosure will be described in detail with reference to the accompanying drawings. It should be noted that the same reference numerals will be used in different drawings to refer to the same elements that have been described.

At least one embodiment of the present disclosure provides a display substrate, and the display substrate comprises a display region. The display region comprises a first display region and a second display region that do not overlap with each other, the second display region at least partially surrounds the first display region, and light transmittance of the first display region is greater than light transmittance of the second display region. The first display region comprises at least one first light-emitting element, and the second display region comprises at least one first pixel circuit. The display region further comprises at least one first connection line, and the first connection line comprises a first end located in the first display region and a second end located in the second display region. The at least one first light-emitting element comprises a first light-emitting sub-element, and the at least one first pixel circuit comprises a first pixel sub-circuit, the first end of the first connection line is electrically connected to an anode of the first light-emitting sub-element, and the second end of the first connection line is electrically connected to the first pixel sub-circuit. The display substrate comprises a first connection layer, a first insulation layer, a second insulation layer, and an anode layer that are stacked in sequence. The first connection line is in the first connection layer, the anode of the first light-emitting sub-element is in the anode layer, and the anode of the first light-emitting sub-element is electrically connected to the first connection line through a first hole penetrating the first insulation layer and the second insulation layer. A shape of a cross section of the first hole in a plane perpendicular to the display substrate is an inverted convex shape, and in the first hole, a diameter of an opening of the second insulation layer is larger than a diameter of an opening of the first insulation layer. The anode of the first light-emitting sub-element comprises a first groove structure, the first groove structure is in the first hole, and a bottom of the first groove structure is in contact with the first connection line for realizing electrical connection.

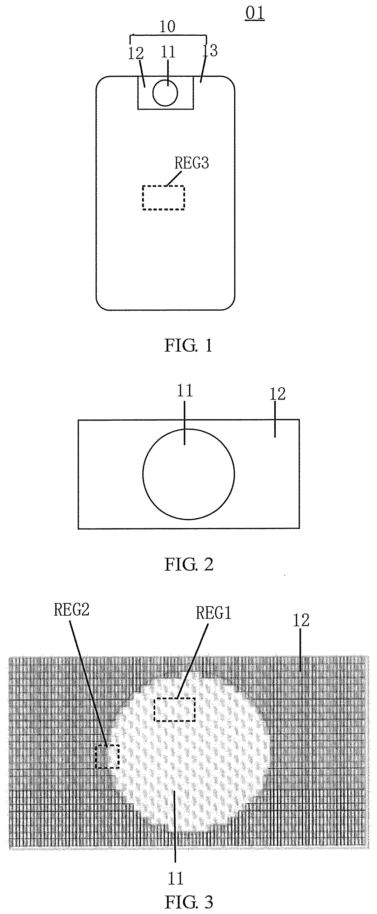

FIG. 1 is a schematic plane view of a display substrate provided by at least one embodiment of the present disclosure. As illustrated in FIG. 1, the display substrate 01 includes a display region 10, and the display region 10 includes a first display region 11, a second display region 12, and a third display region 13. For example, the first display region 11, the second display region 12, and the third display region 13 do not overlap with each other. For example, the third display region 13 at least partially surrounds (e.g., partially surrounds) the second display region 12, and the second display region 12 at least partially surrounds (e.g., completely surrounds) the first display region 11. It should be noted that, in some examples, the display substrate 01 may further include a peripheral region, and the peripheral region at least partially surrounds the third display region 13.

For example, the light transmittance of the first display region 11 is greater than the light transmittance of the second display region 12. For example, in some examples, at least the first display region 11 allows light to pass through. For example, the display substrate 01 has a first side for display and a second side opposite to the first side. For example, in some examples, as illustrated in FIG. 1, the first side is a front side of the display substrate 01 (i.e., the plane illustrated in FIG. 1), and the second side is a back side of the display substrate 01. For example, a sensor may be provided on a position, corresponding to the first display region 11, of the second side of the display substrate 01, and the sensor may be, for example, an image sensor or an infrared sensor. The sensor is configured to receive light from the first side of the display substrate 01, so as to perform operations such as image shooting, distance sensing, light intensity sensing, etc., these light rays, for example, pass through the first display region 11 and then irradiate onto the sensor, so as to be sensed by the sensor.

FIG. 2 is a schematic plane view of a first display region and a second display region of the display substrate illustrated in FIG. 1. For example, as illustrated in FIG. 1 and FIG. 2, the second display region 12 at least partially surrounds (e.g., completely surrounds) the first display region 11.

For example, a shape of the first display region 11 may be a circle or an ellipse, and a shape of the second display region 12 may be a rectangle, but the embodiments of the present disclosure are not limited thereto. For another example, the shape of the first display region 11 and the shape of the second display region 12 may both be rectangles or other suitable shapes.

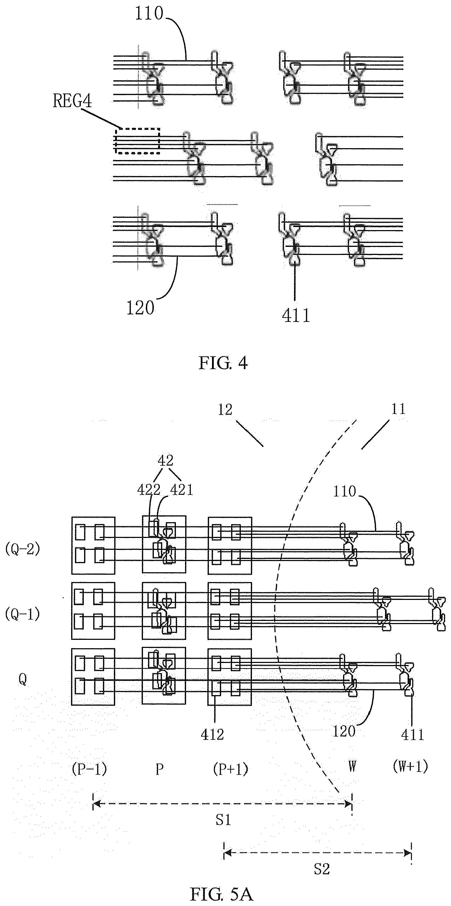

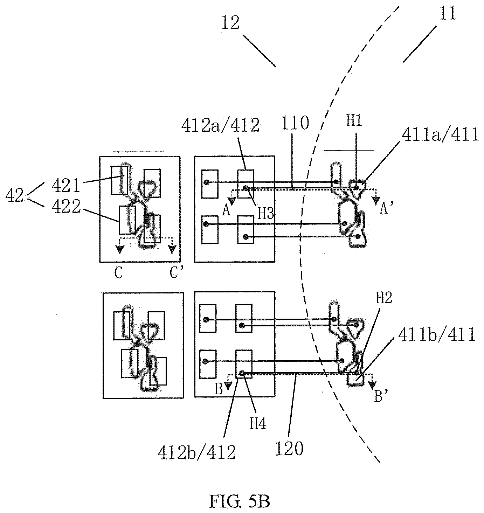

FIG. 3 is an example of the first display region and the second display region, illustrated in FIG. 2, of the display substrate. FIG. 4 is an enlarged view of a partial region REG1 in FIG. 3; FIG. 5A is an enlarged view of a partial region REG2 in FIG. 3; and FIG. 5B is an enlarged view of a region in FIG. 5A including only one column of first pixel circuits, one column of first light-emitting elements, one column of second pixel circuits, and one column of second light-emitting elements. It should be noted that, in order to clearly illustrate the connection mode between the first pixel circuit and the first light-emitting element, FIG. 5B illustrates that the first pixel circuits are connected to the adjacent first light-emitting elements, however, according to FIG. 3, FIG. 4, and FIG. 5A, it can be understood that the left side of the first light-emitting element in FIG. 5B may also be provided with other unillustrated first light-emitting elements, and the right side of the first pixel circuit may also be provided with other unillustrated first pixel circuits.

For example, as illustrated in FIG. 3, FIG. 4, FIG. 5A, and FIG. 5B, the first display region 11 includes at least one (e.g., a plurality of) first light-emitting element 411. It should be noted that, for the sake of clarity, the related drawings use the anode structure of the first light-emitting element 411 to schematically illustrate the first light-emitting element 411. For example, the first display region 11 includes a plurality of first light-emitting elements 411 arranged in an array, and the first light-emitting elements 411 are configured to emit light. For example, no pixel circuit is provided in the first display region 11, and the pixel circuit for driving the first light-emitting element 411 is arranged in the second display region 12, thereby reducing the metal coverage area of the first display region 11 and increasing the light transmittance of the first display region 11. Therefore, the light transmittance of the first display region 11 is larger than that of the second display region 12.

For example, the plurality of first light-emitting elements 411 may be arranged in a plurality of light-emitting units, and these light-emitting units are arranged in an array. For example, each light-emitting unit may include one or more first light-emitting elements 411. For example, the plurality of first light-emitting elements 411 may emit light of the same color or light of different colors, for example, may emit white light, red light, blue light, green light, etc., which may be determined according to actual requirements, and the embodiments of the present disclosure are not limited thereto. For example, the arrangement of the plurality of first light-emitting elements 411 may be referred to the conventional arrangement of pixel units, such as GGRB, RGBG, RGB, etc., which is not limited in the embodiments of the present disclosure.

For example, the first display region 11 allows light from the first side of the display substrate 01 to be at least partially transmitted to the second side of the display substrate 01. In this way, it is convenient to arrange a sensor at a position, corresponding to the first display region 11, of the second side of the display substrate 01, and the sensor can receive light from the first side, so that operations, such as image shooting, distance detection, and light intensity detection, can be performed.

For example, as illustrated in FIG. 3, FIG. 4, FIG. 5A, and FIG. 5B, the second display region 12 includes at least one (e.g., a plurality of) first pixel circuit 412. For example, the first light-emitting elements 411 are electrically connected to the first pixel circuits 412 in one-to-one correspondence, and the plurality of first pixel circuits 412 are used to drive the plurality of first light-emitting elements 411 in one-to-one correspondence. For example, the rectangular boxes illustrated in FIG. 5B (the black border and the white filled region indicated by the reference numeral 412) represent the first pixel driving units, and each first pixel driving unit includes the first pixel circuit 412. For example, the first pixel circuits 412 are configured to drive the plurality of first light-emitting elements 411 to emit light in one-to-one correspondence. That is, one first pixel circuit 412 drives one corresponding first light-emitting element 411, and different first pixel circuits 412 drive different first light-emitting elements 411.

It should be noted that, in FIG. 3, FIG. 4, FIG. 5A, and FIG. 5B, the first pixel driving unit may include one or more first pixel circuits 412. In the case where the light-emitting unit in the first display region 11 includes one first light-emitting element 411, the first pixel driving unit also includes one first pixel circuit 412. In the case where the light-emitting unit in the first display region 11 includes a plurality of first light-emitting elements 411, the first pixel driving unit also includes a plurality of first pixel circuits 412, and the amount of the first light-emitting elements 411 in each light-emitting unit is, for example, equal to the amount of the first pixel circuits 412 in each first pixel driving unit, thereby implementing driving in one-to-one correspondence.

For example, the plurality of first light-emitting elements 411 are arranged in an array, and the plurality of first pixel circuits 412 are also arranged in an array. Here, "arranged in an array" may refer to the case where a plurality of devices belong to one group and a plurality of groups of devices are arranged in an array, or may also refer to the case where a plurality of devices themselves are arranged in an array, and the embodiments of the present disclosure do not limit this. For example, in some examples, as illustrated in FIG. 3, FIG. 4, FIG. 5A, and FIG. 5B, every four first light-emitting elements 411 belong to one group, and a plurality of groups of first light-emitting elements 411 are arranged in an array. Correspondingly, every four first pixel circuits 412 belong to one group, a plurality of groups of first pixel circuits 412 are arranged in an array, and in this case, each first pixel driving unit includes four first pixel circuits 412.

For example, as illustrated in FIG. 3, FIG. 4, FIG. 5A, and FIG. 5B, the display region 10 further includes at least one first connection line 110 and at least one second connection line 120. The first connection line 110 includes a first end located in the first display region 11 and a second end located in the second display region 12, that is, the first connection line 110 extends from the first display region 11 to the second display region 12. Similarly, the second connection line 120 includes a first end located in the first display region 11 and a second end located in the second display region 12, that is, the second connection line 120 extends from the first display region 11 to the second display region 12.

The first light-emitting elements 411 include a first light-emitting sub-element 411a and a second light-emitting sub-element 411b, and the first pixel circuits 412 include a first pixel sub-circuit 412a and a second pixel sub-circuit 412b. The first end of the first connection line 110 is electrically connected to the anode of the first light-emitting sub-element 411a, the second end of the first connection line 110 is electrically connected to the first pixel sub-circuit 412a, and the first connection line 110 is configured to transmit the electrical signal provided by the first pixel sub-circuit 412a to the anode of the first light-emitting sub-element 411a, thereby driving the first light-emitting sub-element 411a to emit light. The first end of the second connection line 120 is electrically connected to the anode of the second light-emitting sub-element 411b, the second end of the second connection line 120 is electrically connected to the second pixel sub-circuit 412b, the second connection line 120 is configured to transmit the electrical signal provided by the second pixel sub-circuit 412b to the anode of the second light-emitting sub-element 411b, thereby driving the second light-emitting sub-element 411b to emit light.

For example, for the plurality of first light-emitting elements 411 located in the first display region 11, a part of the first light-emitting elements 411 (e.g., the first light-emitting sub-elements 411a) is electrically connected to the first connection line 110, another part of the first light-emitting elements 411 (for example, the second light-emitting sub-elements 411b) is electrically connected to the second connection line 120, so that all the first light-emitting elements 411 are electrically connected to the corresponding first pixel circuits 412 through the corresponding connection lines, respectively, thereby implementing the driving of the first light-emitting elements 411.

For example, the first connection line 110 and the second connection line 120 are located in different film layers of the display substrate 01, that is, the first connection line 110 and the second connection line 120 are located in two different film layers. Because the first connection line 110 and the second connection line 120 are located in different film layers, the orthographic projection of the first connection line 110 on the display substrate 01 and the orthographic projection of the second connection line 120 on the display substrate 01 can overlap with each other, so that the wiring space can be effectively utilized, which is convenient for wiring, and therefore, all the first light-emitting elements 411 in the first display region 11 are electrically connected to the corresponding connection lines. Even if the amount of the first light-emitting elements 411 is large and the corresponding connection lines are many, the display substrate 01 can also provide sufficient wiring space.

It should be noted that different film layers are insulated from each other at positions where no holes are provided. For example, when wiring lines in different film layers need to be electrically connected to each other, the wiring lines in different film layers can be electrically connected by means of holes. For example, these different film layers are manufactured in different processes, for example, one of these different film layers is first manufactured by using the first process, and then another of these different film layers is manufactured by using the second process. For example, after the first process is performed and before the second process is performed, a third process may also be used to manufacture an insulation layer, the insulation layer is located between the different film layers, so as to insulate the different film layers from each other at positions where the holes are not provided. For example, the first process, the second process, and the third process may be the same or different. For example, when the display substrate 01 includes a base substrate, in a direction perpendicular to the base substrate, different film layers have different distances from the base substrate. That is, in different film layers, one film layer is closer to the base substrate, while the other film layer is away from the base substrate. In the following description, for the meanings of different film layers, reference can be made to the above description, and will not be repeated.

It should be noted that, in the embodiments of the present disclosure, the connection lines used to implement the electrical connection between the first light-emitting element 411 and the first pixel circuit 412 are not limited to be located in two different film layers, but can also be located in 3 different film layers, 4 different film layers, or any amount of film layers, that is, these connection lines are not limited to the first connection line 110 and the second connection line 120 described above, and may also include other connection lines located in film layers different from the film layers where the first connection line 110 and the second connection line 120 are located, and the embodiments of the present disclosure do not limit this.

For example, as illustrated in FIG. 5A, a plurality of first connection lines 110 and a plurality of second connection lines 120 constitute a connection line array, and each connection line (the connection line may be the first connection line 110 or the second connection line 120) in the connection line array makes one first light-emitting element 411 and one first pixel circuit 412 be correspondingly electrically connected. For example, in order to keep the length difference of the plurality of connection lines not too large and improve the balance of the circuit environment, the spacing between the first light-emitting element 411 and the first pixel circuit 412 that are correspondingly connected can be substantially similar during the wiring design. For example, in the example illustrated in FIG. 5A, a plurality of pixel circuits (including the first pixel circuit 412 and the second pixel circuit 422) are arranged in an array, and a plurality of first light-emitting elements 411 are also arranged in an array. For pixel circuits and first light-emitting elements 411 located in a Q-th row, a first pixel circuit 412 in a (P-1)-th column is electrically connected to a first light-emitting element 411 in a W-th column through a connection line (which may be the first connection line 110 or the second connection line 120), and a length of the connection line is, for example, about S1; a first pixel circuit 412 in a (P+1)-th column is electrically connected to a first light-emitting element 411 in a (W+1)-th column through a connection line (which may be the first connection line 110 or the second connection line 120), and a length of the connection line is, for example, about S2. For example, the difference between S1 and S2 is within a certain range and is not too large. For example, the specific value of the difference range between S1 and S2 may be determined according to actual requirements, which is not limited in the embodiments of the present disclosure. Similarly, the first pixel circuits 412 and the first light-emitting elements 411 located in the (Q-1)-th row and the (Q-2)-th row may adopt a similar wiring mode.

Compared with a situation where the first pixel circuit 412 in the (P-1)-th column is connected to the first light-emitting element 411 in the (W+1)-th column and the first pixel circuit 412 in the (P+1)-th column is connected to the first light-emitting element 411 in the W-th column, the example illustrated in FIG. 5A can make the length difference of the plurality of connection lines not too large, that is, the length difference of the plurality of first connection lines 110 is not too large, the length difference of the plurality of second connection lines 120 is not too large, and the length difference between the first connection line 110 and the second connection line 120 is not too large, so that the balance of the circuit environment can be improved. Of course, the embodiments of the present disclosure are not limited to the situation illustrated in FIG. 5A, and the distribution positions of the first pixel circuits 412 and the first light-emitting elements 411 connected by the connection lines can also be other positions, and can be determined according to actual needs. The embodiments of the present disclosure are not limited in this regard.

It should be noted that the distribution manner and the positional relationship of the plurality of first connection lines 110 and the plurality of second connection lines 120 in a plane parallel to the display substrate 01 are not limited, and may be determined according to actual wiring requirements. For example, in the plane parallel to the display substrate 01, the first connection lines 110 and the second connection lines 120 may be arranged at intervals one by one, or may also be arranged at intervals in groups, or may be distributed irregularly, and the embodiments of the present disclosure are not limited thereto.

It should be noted that, in the embodiments of the present disclosure, the first light-emitting sub-element 411a and the second light-emitting sub-element 411b may have no difference in structure and function, the first pixel sub-circuit 412a and the second pixel sub-circuit 412b may also have no difference in structure and function, they are called "first" and "second" only to distinguish the connection lines (i.e., the first connection line 110 and the second connection line 120) connected to these light-emitting elements and pixel circuits, which do not constitute a limitation on the embodiments of the present disclosure.

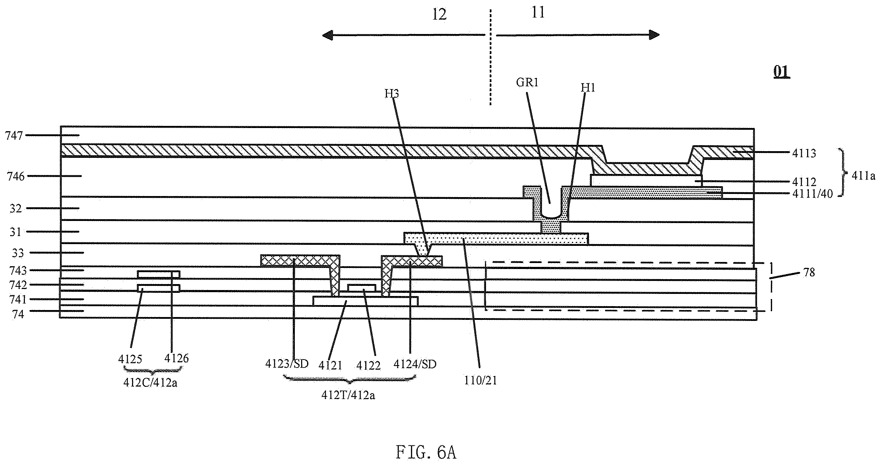

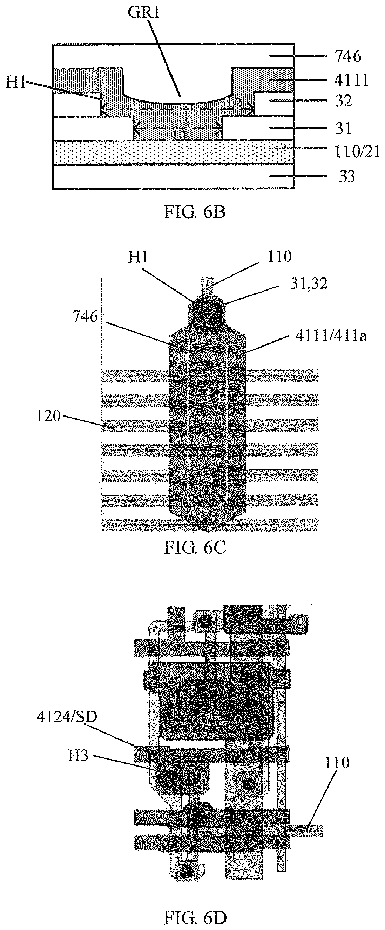

FIG. 6A is a schematic view of a cross section along a line A-A' in FIG. 5B, FIG. 6B is an enlarged view of a first hole H1 in FIG. 6A, FIG. 6C is a schematic layout diagram of a region corresponding to the first hole H1 and a connected anode in FIG. 6A, and FIG. 6D is a schematic layout diagram of a region corresponding to a third hole H3 and a connected source-drain metal layer in FIG. 6A.

For example, as illustrated in FIG. 6A to FIG. 6D, the display substrate 01 includes a third insulation layer 33, a first connection layer 21, a first insulation layer 31, a second insulation layer 32, and an anode layer 40 that are stacked in sequence. The first light-emitting sub-element 411a includes an anode 4111, a cathode 4113, and a light-emitting layer 4112 located between the anode 4111 and the cathode 4113. The first connection line 110 is located in the first connection layer 21, and the anode 4111 of the first light-emitting sub-element 411a is located in the anode layer 40. The anode 4111 of the first light-emitting sub-element 411a is electrically connected to the first connection line 110 through the first hole H1 penetrating the first insulation layer 31 and the second insulation layer 32.

For example, a shape of a cross section of the first hole H1 in a plane perpendicular to the display substrate 01 is an inverted convex shape. In the cross-sectional view illustrated (e.g., FIG. 6A and FIG. 6B), the inverted convex shape can be regarded as a shape formed by splicing two rectangles of different sizes, the rectangle located above is larger, and the rectangle located below is smaller, so that a step is formed on at least one side of the inverted convex shape, for example, steps are formed on both sides; for example, the orthographic projection of the portion corresponding to the rectangle located below on the base substrate 74 is completely inside the orthographic projection of the portion corresponding to the rectangle located above on the base substrate 74, for example, each edge of the orthographic projection of the portion corresponding to the rectangle located below on the base substrate 74 is spaced apart from each edge of the orthographic projection of the portion corresponding to the rectangle located above on the base substrate 74. For example, in the first hole H1, a diameter L2 of an opening of the second insulation layer 32 is larger than a diameter L1 of an opening of the first insulation layer 31. For example, the diameter L2 of the opening of the second insulation layer 32 may be 6 $\mu$m×6 $\mu$m, or the diameter L1 of the opening of the first insulation layer 31 may be 6 $\mu$m×6 $\mu$m. Because the first hole H1 needs to penetrate two insulation layers, the depth of the first hole H1 is relatively large. By setting the first hole H1 in the shape of an inverted convex shape, the manufacturing difficulty of the first hole H1 can be reduced, and it is convenient for the conductive material (for example, the material of the anode 4111) to be deposited in the first hole H1, thereby improving the reliability of electrical connection.

For example, the anode 4111 of the first light-emitting sub-element 411a includes a first groove structure GR1, the first groove structure GR1 is located in the first hole H1, and the bottom of the first groove structure GR1 is in contact with the first connection line 110 for realizing electrical connection. By setting the portion, which is deposited in the first hole H1, of the anode 4111 into a groove structure, the thickness of this portion can be reduced, the thickness of this portion is not much different from the thickness of other portions of the anode 4111, so as to improve the uniformity of the transmitted light as a whole, so that there is no obvious difference in brightness between different regions, in addition, the first display region 11 has better light transmittance, thereby helping to improve the sensing effect of the under-screen sensor (e.g., camera), for example, making the image clearer. Because the first hole H1 is in the shape of an inverted convex shape, when the anode 4111 is prepared, it is beneficial to form the groove structure, which can reduce the difficulty of the process.

For example, in some examples, the surface of the first groove structure GR1 away from the first connection layer 21 is a curved surface. In this way, the light intensity of the transmitted light can continuously change to avoid the sudden change of the light intensity at a local position, thereby further improving the uniformity of the transmitted light. Of course, the embodiments of the present disclosure are not limited thereto, and in other examples, the surface of the first groove structure GR1 away from the first connection layer 21 may also be a flat surface, an inclined surface, etc., which may be determined according to actual requirements.

For example, the anode 4111 may include a plurality of anode sub-layers, such as an ITO/Ag/ITO three-layer structure (not illustrated in the figure), and the embodiments of the present disclosure do not limit the specific form of the anode 4111. For example, the cathode 4113 may be a structure formed on the entire surface of the display substrate 01, and the cathode 4113 may include, for example, lithium (Li), aluminum (Al), magnesium (Mg), silver (Ag), and other metal materials. For example, because the cathode 4113 can be formed as a very thin layer, the cathode 4113 has good light transmittance. For example, when the anode 4111 includes the ITO/Ag/ITO three-layer structure, the thickness of the anode 4111 may be 86/1000/86A.

It should be noted that, in the layout illustrated in FIG. 6C, because the second connection line 120 is located in a film layer different from the film layer where the first connection line 110 is located (the film layer where the second connection line 120 is located and the corresponding cross-sectional structure will be described later), and the second connection line 120 and the anode 4111 of the first light-emitting sub-element 411a are also located in different film layers, although the outline of the second connection line 120 overlaps with the anode 4111 of the first light-emitting sub-element 411a, the second connection line 120 is not electrically connected to the anode 4111 of the first light-emitting sub-element 411a.

For example, as illustrated in FIG. 6A, the first pixel sub-circuit 412a includes structures such as a first switch transistor (e.g., a switch thin film transistor 412T) and a storage capacitor 412C. The switch thin film transistor 412T includes a gate electrode 4121, an active layer 4122, a first electrode 4123, and a second electrode 4124. For example, the first electrode 4123 may be a source electrode or a drain electrode, and the second electrode 4124 may be a drain electrode or a source electrode. For example, the storage capacitor 412C includes a first capacitor plate 4125 and a second capacitor plate 4126.

For example, the active layer 4121 is disposed on the base substrate 74, and a first gate insulation layer 741 is disposed on the side of the active layer 4121 away from the base substrate 74. The gate electrode 4122 and the first capacitor plate 4125 are arranged in the same layer and are located on the side of the first gate insulation layer 741 away from the base substrate 74, and a second gate insulation layer 742 is provided on the side of the gate electrode 4122 and the first capacitor plate 4125 away from the base substrate 74. The second capacitor plate 4126 is disposed on the side of the second gate insulation layer 742 away from the base substrate 74, and an interlayer insulation layer 743 is disposed on the side of the second capacitor plate 4126 away from the base substrate 74. The first electrode 4123 and the second electrode 4124 (that is, the source electrode and the drain electrode) are disposed on the side of the interlayer insulation layer 743 away from the base substrate 74, and are electrically connected to the active layer 4121 through holes in the first gate insulation layer 741, the second gate insulation layer 742, and the interlayer insulation layer 743. The first electrode 4123 and the second electrode 4124 are both located in the source-drain metal layer SD, the third insulation layer 33 is located on the source-drain metal layer SD, and the first connection layer 21 is located on the third insulation layer 33. The third insulation layer 33 can not only play a role of insulation, but also play a role of planarization.

For example, the second end of the first connection line 110 is electrically connected to the second electrode 4124 of the first switch transistor (e.g., the switch thin film transistor 412T) included in the first pixel sub-circuit 412a through the third hole H3 penetrating the third insulation layer 33. Of course, the embodiments of the present disclosure are not limited thereto, and in other examples, the second end of the first connection line 110 may also be electrically connected to the first electrode 4123 of the switch thin film transistor 412T included in the first pixel sub-circuit 412a. For example, the size of the cross section of the third hole H3 in the plane parallel to the display substrate 01 may be 4 $\mu$m×4 $\mu$m.

For example, the first display region 11 further includes a transparent support layer 78 located on the base substrate 74, and the first light-emitting sub-element 411a is located on a side of the transparent support layer 78 away from the base substrate 74. Therefore, with respect to the base substrate 74, the first light-emitting sub-element 411a in the first display region 11 may be at substantially the same height as the light-emitting elements in other display regions (for example, the second light-emitting element 421 in the second display region 12 and the third light-emitting element 431 in the third display region 13 described later), so that the display effect of the display substrate 01 can be improved.

For example, the display substrate 01 may further include a pixel defining layer 746, an encapsulation layer 747, and other structures. For example, the pixel defining layer 746 is disposed on the anode 4111 (e.g., a part structure of the anode 4111) and includes a plurality of openings to define different pixels or sub-pixels, and the light-emitting layer 4112 is formed in the opening of the pixel defining layer 746. For example, the horizontal distance between the opening of the pixel defining layer 746 and the first hole H1 may be 4.6 $\mu$m. For example, the encapsulation layer 747 may comprise a single-layer or multi-layer encapsulation structure, the multi-layer encapsulation structure includes, for example, a stack of an inorganic encapsulation layer and an organic encapsulation layer, thereby improving the encapsulation effect on the display substrate 01.

For example, the pixel defining layers 746 in the first display region 11, the second display region 12, and the third display region 13 are provided in the same layer, the encapsulation layers 747 in the first display region 11, the second display region 12, and the third display region 13 are provided on the same layer, and in some embodiments, are also integrally connected, and the embodiments of the present disclosure do not limit this.

For example, in various embodiments of the present disclosure, the base substrate 74 may be a glass substrate, a quartz substrate, a metal substrate, or a resin substrate, etc., and may be a rigid substrate or a flexible substrate, and the embodiments of the present disclosure do not limit this.

For example, the first gate insulation layer 741, the second gate insulation layer 742, the interlayer insulation layer 743, the first insulation layer 31, the second insulation layer 32, the third insulation layer 33, the pixel defining layer 746, and the encapsulation layer 747 can include inorganic insulation materials such as silicon oxide, silicon nitride, silicon oxynitride, etc., or may include organic insulation materials such as polyimide, polyphthalimide, polyphthalamide, acrylic resin, benzocyclobutene, or phenolic resin. The embodiments of the present disclosure do not specifically limit the materials of the above-mentioned functional layers. For example, the thickness of the first insulation layer 31, the thickness of the second insulation layer 32, and the thickness of the third insulation layer 33 maybe 10000~15000A, respectively.

For example, the material of the active layer 4121 may include a semiconductor material such as polysilicon or an oxide semiconductor (e.g., indium gallium zinc oxide). For example, a portion of the active layer 4121 may be conductive by conducting a conductive treatment such as doping, so as to have high conductivity.

For example, the materials of the gate electrode 4122, the first capacitor electrode plate 4125, and the second capacitor electrode plate 4126 may include metal materials or alloy materials, such as molybdenum, aluminum, and titanium.

For example, the materials of the first electrode 4123 and the second electrode 4124 may include metal materials or alloy materials, such as a metal single-layer or multi-layer structure formed of molybdenum, aluminum, titanium, etc., for example, the multi-layer structure is a multi-metal laminated layer, such as three-layer metal laminated layer of titanium, aluminum, titanium (Ti/Al/Ti), and so on.

For example, the display substrate 01 provided by the embodiments of the present disclosure may be an organic light-emitting diode (OLED) display substrate or a quantum dot light-emitting diode (QLED) display substrate, etc. The embodiments of the present disclosure do not limit the specific type of the display substrate.

For example, in the case where the display substrate 01 is an organic light-emitting diode display substrate, the light-emitting layer (e.g., the aforementioned light-emitting layer 4112) may include small molecular organic materials or polymer molecular organic materials, may be fluorescent light-emitting materials or phosphorescent light-emitting materials, may emit red light, green light, blue light, or may emit white light, etc. Moreover, according to different actual needs, in different examples, the light-emitting layer may further include functional layers such as an electron injection layer, an electron transport layer, a hole injection layer, a hole transport layer, etc.

For example, in the case where the display substrate 01 is a quantum dot light-emitting diode (QLED) display substrate, the light-emitting layer (e.g., the aforementioned light-emitting layer 4112) may include quantum dot materials, such as silicon quantum dots, germanium quantum dots, cadmium sulfide quantum dots, cadmium selenide quantum dots, cadmium telluride quantum dots, zinc selenide quantum dots, lead sulfide quantum dots, lead selenide quantum dots, indium phosphide quantum dots, indium arsenide quantum dots, etc. The particle size of the quantum dot is, for example, 2nm~20nm.

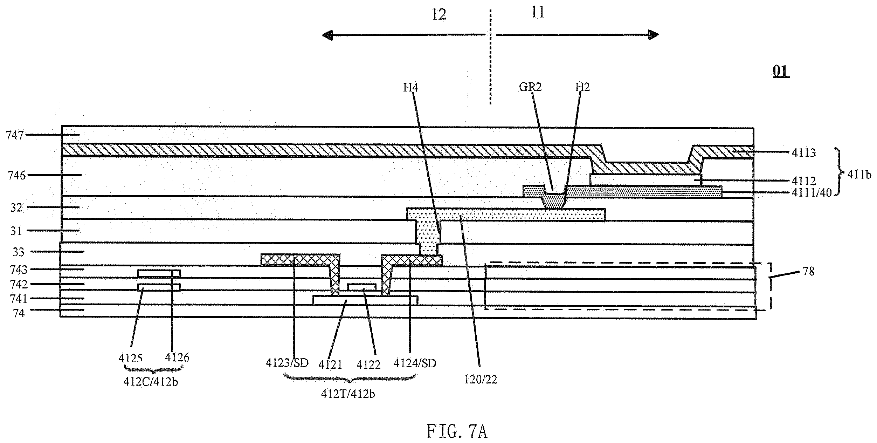

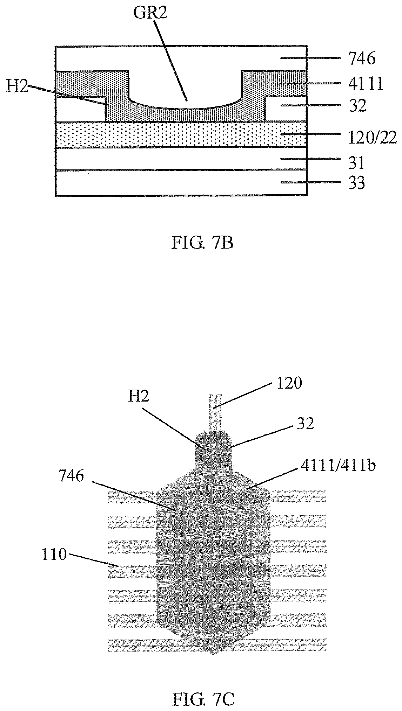

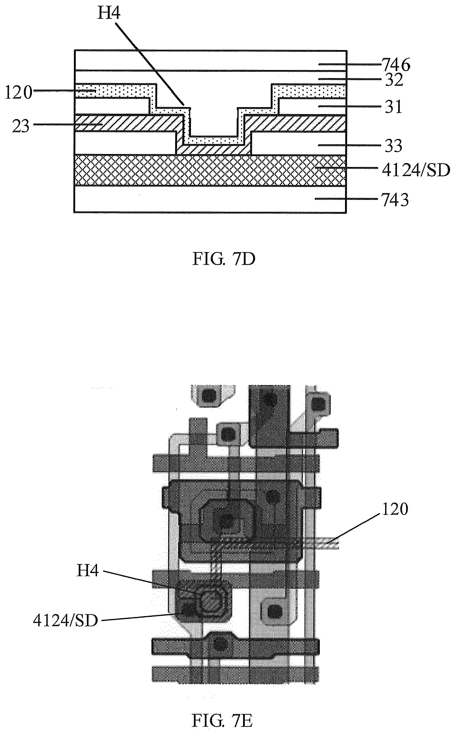

FIG. 7A is a schematic view of a cross section along a line B-B' in FIG. 5B; FIG. 7B is an enlarged view of a second hole H2 in FIG. 7A; FIG. 7C is a schematic layout diagram of a region corresponding to the second hole H2 and a connected anode in FIG. 7A; FIG. 7D is another schematic structural diagram of a fourth hole H4; and FIG. 7E is a schematic layout diagram of a region corresponding to the fourth hole H4 and a connected source-drain metal layer in FIG. 7A.

For example, as illustrated in FIG. 7A to FIG. 7E, the display substrate 01 further includes a second connection layer 22, and the second connection layer 22 is located between the first insulation layer 31 and the second insulation layer 32, and the second connection line 120 is located in the second connection layer 22. The arrangement of the second light-emitting sub-element 411b is similar to the arrangement of the first light-emitting sub-element 411a. The setting manner of the first switch transistor (e.g., the switch thin film transistor 412T) and the storage capacitor 412C included in the second pixel sub-circuit 412b is similar to the setting manner of the first switch transistor and the storage capacitor 412C in the first pixel sub-circuit 412a, reference may be made to the descriptions of FIG. 6A to FIG. 6D above, which will not be repeated here.

For example, the anode 4111 of the second light-emitting sub-element 411b is located in the anode layer 40, and the anode 4111 of the second light-emitting sub-element 411b is electrically connected to the second connection line 120 through the second hole H2 penetrating the second insulation layer 32.

For example, the anode 4111 of the second light-emitting sub-element 411b includes a second groove structure GR2, the second groove structure GR2 is located in the second hole H2, and the bottom of the second groove structure GR2 is in contact with the second connection line 120 for realizing electrical connection. By setting the portion of the anode 4111 deposited in the second hole H2 into a groove structure, the thickness of this portion can be reduced, so that the thickness of this portion is not much different from the thickness of other portions of the anode 4111, so as to improve the uniformity of the transmitted light as a whole.

For example, in some examples, a surface of the second groove structure GR2 away from the second connection layer 22 is a curved surface. In this way, the light intensity of the transmitted light can be continuously change to avoid the sudden change of the light intensity at a local location, thereby further improving the uniformity of the transmitted light. Of course, the embodiments of the present disclosure are not limited thereto, and in other examples, the surface of the second groove structure GR2 away from the second connection layer 22 may also be a flat surface, an inclined surface, etc., which may be determined according to actual requirements.

For example, the second end of the second connection line 120 is electrically connected to the second electrode 4124 of the first switch transistor (e.g., switch thin film transistor 412T) of the second pixel sub-circuit 412b through the fourth hole H4 penetrating the third insulation layer 33 and the first insulation layer 31. Of course, the embodiments of the present disclosure are not limited thereto, in other examples, the second end of the second connection line 120 may also be electrically connected to the first electrode 4123 of the switch thin film transistor 412T included in the second pixel sub-circuit 412b.

For example, as illustrated in FIG. 7A, a shape of a cross section of the fourth hole H4 in the plane perpendicular to the display substrate 01 is an inverted convex shape. For example, in the fourth hole H4, a diameter of an opening of the first insulation layer 31 is larger than a diameter of an opening of the third insulation layer 33. Because the fourth hole H4 needs to penetrate two insulation layers, the depth of the fourth hole H4 is relatively large. By setting the fourth hole H4 in the shape of an inverted convex, the manufacturing difficulty of the fourth hole H4 can be reduced, and it is convenient for the conductive material (for example, the material of the second connection line 120) to be deposited in the fourth hole H4, thereby improving the reliability of electrical connection.

It should be noted that, in the layout illustrated in FIG. 7C, because the first connection line 110 is located in a film layer different from the film layer where the second connection line 120 is located, and the first connection line 110 and the anode 4111 of the second light-emitting sub-element 411b are also located in different layers, although the outline of the first connection line 110 overlaps with the anode 4111 of the second light-emitting sub-element 411b, the first connection line 110 is not electrically connected to the anode 4111 of the second light-emitting sub-element 411b.

It should be noted that the connection mode between the second connection line 120 and the first switch transistor (e.g., the switch thin film transistor 412T) is not limited to the mode illustrated in FIG. 7A, and the electrical connection can also be achieved by providing a transition metal layer, thereby reducing the difficulty of the process. For example, in other examples, as illustrated in FIG. 7D, in the fourth hole H4, the second connection line 120 is electrically connected to the transition metal layer 23, and the transition metal layer 23 is in contact with and electrically connected to the first electrode 4123 or the second electrode 4124 of the first switch transistor (e.g., switch thin film transistor 412T) of the second pixel sub-circuit 412b, thereby achieving the electrical connection between the second connection line 120 and the switch thin film transistor 412T. For example, the transition metal layer 23 and the first connection layer 21 are formed in the same process, that is, the transition metal layer 23 and the first connection layer 21 may be the same film layer, and in this film layer, a portion of the structure forms the first connection line 110, and another portion of the structure is used for achieving the electrical connection with the second connection line 120 and the switch thin film transistor 412T of the second pixel sub-circuit 412b. By arranging the transition metal layer 23, the process difficulty can be reduced, and the reliability of the electrical connection can be improved.

For example, as illustrated in FIG. 5B, the second display region 12 further includes at least one (e.g., a plurality of) second light-emitting element 421 and at least one (e.g., a plurality of) second pixel circuit 422. The second light-emitting elements 421 are electrically connected to the second pixel circuits 422 in one-to-one correspondence, and the second pixel circuit 422 is used to drive the second light-emitting element 421 to emit light. It should be noted that the rectangular box indicated by the reference numeral 422 in FIG. 5B is only used to illustrate the approximate position of the second pixel circuit 422, and does not indicate the specific shape of the second pixel circuit 422 and the specific boundary of the second pixel circuit 422. For example, at least one second light-emitting element 421 and its corresponding second pixel circuit 422 constitute one second pixel driving unit 42.

It should be noted that, in FIG. 5B, the second pixel driving unit 42 may include one second pixel circuit 422 and one second light-emitting element 421, or may include a plurality of second pixel circuits 422 and a plurality of second light-emitting elements 421. In the case where the second pixel driving unit 42 includes a plurality of second pixel circuits 422 and a plurality of second light-emitting elements 421, the amount of the second pixel circuits 422 in each second pixel driving unit 42 is, for example, equal to the amount of the second light-emitting elements 421 in each second pixel driving unit 42, thereby achieving driving in one-to-one correspondence.

For example, the plurality of second light-emitting elements 421 are arranged in an array, and the plurality of second pixel circuits 422 are also arranged in an array. Here, "arranged in an array" may refer to the case where a plurality of devices belong to one group and a plurality of groups of devices are arranged in an array, or may also refer to the case where a plurality of devices themselves are arranged in an array, and the embodiments of the present disclosure do not limit this. For example, in some examples, as illustrated in FIG. 5B, every four second light-emitting elements 421 belong to one group, and a plurality of groups of second light-emitting elements 421 are arranged in an array. Correspondingly, every four second pixel circuits 422 belong to one group, a plurality of groups of second pixel circuits 422 are arranged in an array, and in this case, each second pixel driving unit 42 includes four second pixel circuits 422 and four second light-emitting elements 421.

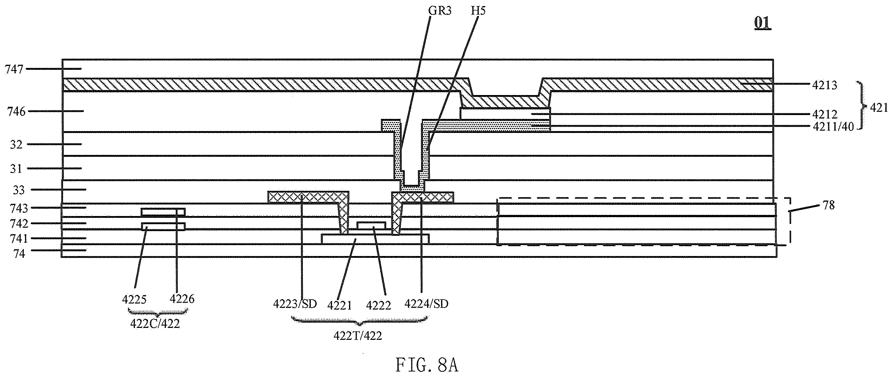

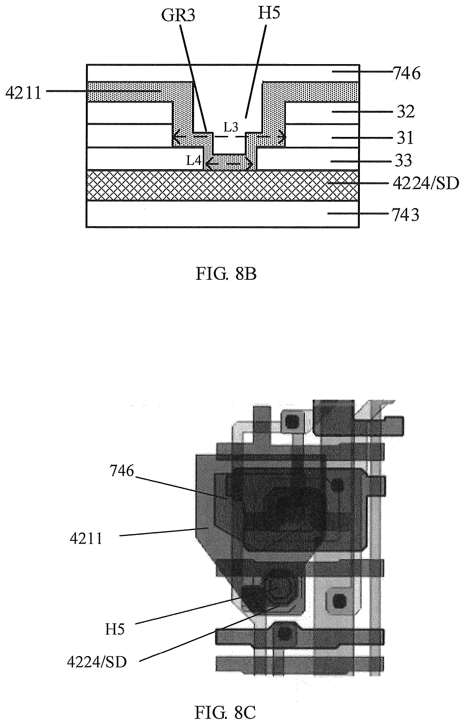

FIG. 8A is a schematic view of a cross section along a line C-C' in FIG. 5B; FIG. 8B is an enlarged view of a fifth hole H5 in FIG. 8A; and FIG. 8C is a schematic layout diagram of a region corresponding to the fifth hole H5 and a connected anode and a connected source-drain metal layer in FIG. 8A.

For example, as illustrated in FIG. 8A to FIG. 8C, the second pixel circuit 422 includes structures such as a second switch transistor (e.g., a switch thin film transistor 422T) and a storage capacitor 422C. The switch thin film transistor 422T includes a gate electrode 4221, an active layer 4222, a first electrode 4223, and a second electrode 4224. For example, the first electrode 4223 may be a source electrode or a drain electrode, and the second electrode 4224 may be a drain electrode or a source electrode. For example, the storage capacitor 422C includes a first capacitor plate 4225 and a second capacitor plate 4226.

For example, the active layer 4221 is disposed on the base substrate 74, and the first gate insulation layer 741 is disposed on the side of the active layer 4221 away from the base substrate 74. The gate electrode 4222 and the first capacitor plate 4225 are disposed in the same layer, and are located on the side of the first gate insulation layer 741 away from the base substrate 74, and a second gate insulation layer 742 is provided on the sides of the gate electrode 4222 and the first capacitor plate 4225 away from the base substrate 74. The second capacitor plate 4226 is disposed on the side of the second gate insulation layer 742 away from the base substrate 74, and the interlayer insulation layer 743 is disposed on the side of the second capacitor plate 4226 away from the base substrate 74. The first electrode 4223 and the second electrode 4224 (i.e., the source electrode and the drain electrode) are disposed on the side of the interlayer insulation layer 743 away from the base substrate 74, and are electrically connected to the active layer 4221 through the holes in the first gate insulation layer 741, the second gate insulation layer 742, and the interlayer insulation layer 743. The first electrode 4223 and the second electrode 4224 are both located in the source-drain metal layer SD, and the third insulation layer 33 is located on the source-drain metal layer SD. The third insulation layer 33 can not only play a role of insulation, but also play a role of planarization.

For example, the second light-emitting element 421 includes an anode 4211, a cathode 4213, and a light-emitting layer 4212 located between the anode 4211 and the cathode 4213, and the anode 4211 is located in the anode layer 40. The anode 4211 of the second light-emitting element 421 is electrically connected to the first electrode 4223 or the second electrode 4224 of the second switch transistor (e.g., the switch thin film transistor 422T) through the fifth hole H5 penetrating the first insulation layer 31, the second insulation layer 32, and the third insulation layer 33.

For example, the shape of the cross section of the fifth hole H5 in the plane perpendicular to the display substrate 01 is an inverted convex shape. In the fifth hole H5, a diameter L3 of an opening of the first insulation layer 31 is larger than a diameter L4 of an opening of the third insulation layer 33. Because the fifth hole H5 needs to penetrate three insulation layers, the depth of the fifth hole H5 is relatively large. By setting the fifth hole H5 in the shape of an inverted convex, the manufacturing difficulty of the fifth hole H5 can be reduced, and it is convenient for the conductive material (for example, the material of the anode 4211) to be deposited in the fifth hole H5, thereby improving the reliability of electrical connection.

For example, in the fifth hole H5, the diameter of the opening of the second insulation layer 32 is equal to or larger than the diameter of the opening of the first insulation layer 31. For example, as illustrated in FIG. 8A to FIG. 8B, in some examples, the diameter of the opening of the second insulation layer 32 and the diameter of the opening of the first insulation layer 31 are equal to each other, that is, both are equal to L3, so that the opening of the first insulation layer 31 and the opening of the second insulation layer 32 can be prepared by using the same mask, thereby reducing the amount of required masks, and reducing the production cost. For example, in other examples, the diameter of the opening of the second insulation layer 32 may be larger than the diameter of the opening of the first insulation layer 31, so that the fifth hole H5 can be formed into a three-step shape, so as to further reduce the processing difficulty, and facilitate the deposition of the conductive material (e.g., the material of the anode 4211) in the fifth hole H5, so as to further improve the reliability of electrical connection.

For example, the anode 4211 of the second light-emitting element 421 includes a third groove structure GR3, the third groove structure GR3 is located in the fifth hole H5, and the bottom of the third groove structure GR3 is in contact with the first electrode 4223 or the second electrode 4224 of the second switch transistor (e.g., switch thin film transistor 422T) for realizing electrical connection. By setting the portion, which is deposited in the fifth hole H5, of the anode 4211 into a groove structure, the thickness of this portion can be reduced, the thickness of this portion is not much different from the thickness of other portions of the anode 4211, so as to improve the uniformity of the transmitted light as a whole. Because the fifth hole H5 is in the shape of an inverted convex, when the anode 4211 is prepared, it is beneficial to form the groove structure, which can reduce the processing difficulty. For example, the surface of the third groove structure GR3 away from the source-drain metal layer SD may be a curved surface, a flat surface, an inclined surface, etc., and the embodiments of the present disclosure are not limited thereto.

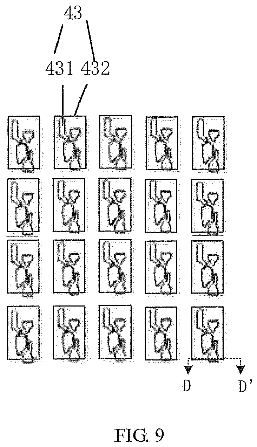

FIG. 9 is an enlarged view of a partial region REG3 of a third display region of the display substrate illustrated in FIG. 1. For example, as illustrated in FIG. 9, the third display region 13 includes at least one (e.g., a plurality of) third light-emitting element 431 and at least one (e.g., a plurality of) third pixel circuit 432. The third light-emitting elements 431 are electrically connected to the third pixel circuits 432 in one-to-one correspondence, and the third pixel circuit 432 is used to drive the third light-emitting element 431 to emit light. It should be noted that the rectangular box indicated by the reference numeral 432 in FIG. 9 is only used to illustrate the approximate position of the third pixel circuit 432, and does not indicate the specific shape of the third pixel circuit 432 and the specific boundary of the third pixel circuit 432. For example, at least one third light-emitting element 431 and its corresponding third pixel circuit 432 constitute one third pixel driving unit 43.

It should be noted that, in FIG. 9, the third pixel driving unit 43 may include one third pixel circuit 432 and one third light-emitting element 431, or may include a plurality of third pixel circuits 432 and a plurality of third light-emitting elements 431. In the case where the third pixel driving unit 43 includes a plurality of third pixel circuits 432 and a plurality of third light-emitting elements 431, the amount of the third pixel circuits 432 in each third pixel driving unit 43 is, for example, equal to the amount of the third light-emitting elements 431 in each third pixel driving unit 43, thereby achieving driving of one-to-one correspondence.

For example, the plurality of third light-emitting elements 431 are arranged in an array, and the plurality of third pixel circuits 432 are also arranged in an array. Here, "arranged in an array" may refer to the case where a plurality of devices belong to one group and a plurality of groups of devices are arranged in an array, may also refer to the case where a plurality of devices themselves are arranged in an array, and the embodiments of the present disclosure do not limit this. For example, in some examples, as illustrated in FIG. 9, every four third light-emitting elements 431 belong to one group, and a plurality of groups of third light-emitting elements 431 are arranged in an array. Correspondingly, every four third pixel circuits 432 belong to one group, a plurality of groups of third pixel circuits 432 are arranged in an array, and in this case, each third pixel driving unit 43 includes four third pixel circuits 432 and four third light-emitting elements 431.

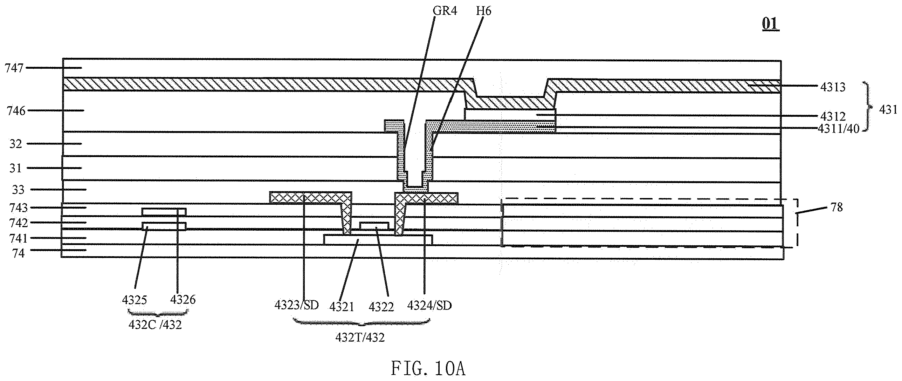

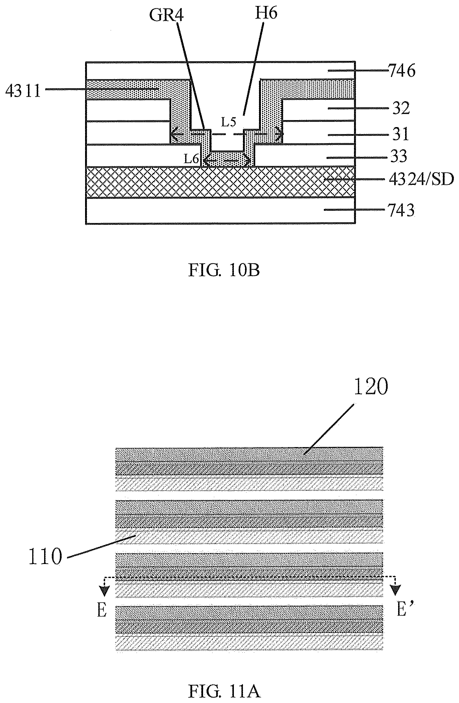

FIG. 10A is a schematic view of a cross section along a line D-D' in FIG. 9; and FIG. 10B is an enlarged view of a sixth hole H6 in FIG. 10A.

For example, as illustrated in FIG. 10A to FIG. 10B, the third pixel circuit 432 includes structures such as a third switch transistor (e.g., a switch thin film transistor 432T) and a storage capacitor 432C. The switch thin film transistor 432T includes a gate electrode 4321, an active layer 4322, a first electrode 4323, and a second electrode 4324. For example, the first electrode 4323 may be a source electrode or a drain electrode, and the second electrode 4324 may be a drain electrode or a source electrode. For example, the storage capacitor 432C includes a first capacitor plate 4325 and a second capacitor plate 4326.

For example, the active layer 4321 is disposed on the base substrate 74, and the first gate insulation layer 741 is disposed on the side of the active layer 4321 away from the base substrate 74. The gate electrode 4322 and the first capacitor plate 4325 are disposed in the same layer, and are located on the side of the first gate insulation layer 741 away from the base substrate 74, and a second gate insulation layer 742 is provided on the sides of the gate electrode 4322 and the first capacitor plate 4325 away from the base substrate 74. The second capacitor plate 4326 is disposed on the side of the second gate insulation layer 742 away from the base substrate 74, and the interlayer insulation layer 743 is disposed on the side of the second capacitor plate 4326 away from the base substrate 74. The first electrode 4323 and the second electrode 4324 (i.e., the source electrode and the drain electrode) are disposed on the side of the interlayer insulation layer 743 away from the base substrate 74, and are electrically connected to the active layer 4321 through the holes in the first gate insulation layer 741, the second gate insulation layer 742, and the interlayer insulation layer 743. The first electrode 4323 and the second electrode 4324 are both located in the source-drain metal layer SD, and the third insulation layer 33 is located on the source-drain metal layer SD. The third insulation layer 33 can not only play a role of insulation, but also play a role of planarization.

For example, the third light-emitting element 431 includes an anode 4311, a cathode 4313, and a light-emitting layer 4312 located between the anode 4311 and the cathode 4313, and the anode 4311 is located in the anode layer 40. The anode 4311 of the third light-emitting element 431 is electrically connected to the first electrode 4323 or the second electrode 4324 of the third switch transistor (e.g., the switch thin film transistor 432T) through the sixth hole H6 penetrating the first insulation layer 31, the second insulation layer 32, and the third insulation layer 33.

For example, the shape of the cross section of the sixth hole H6 in the plane perpendicular to the display substrate 01 is an inverted convex shape. In the sixth hole H6, a diameter L5 of an opening of the first insulation layer 31 is larger than a diameter L6 of an opening of the third insulation layer 33. Because the sixth hole H6 needs to penetrate three insulation layers, the depth of the sixth hole H6 is relatively large. By setting the sixth hole H6 in the shape of an inverted convex, the manufacturing difficulty of the sixth hole H6 can be reduced, and it is convenient for the conductive material (for example, the material of the anode 4311) to be deposited in the sixth hole H6, thereby improving the reliability of electrical connection.

For example, in the sixth hole H6, the diameter of the opening of the second insulation layer 32 is equal to or larger than the diameter of the opening of the first insulation layer 31. For example, as illustrated in FIG. 10A to FIG. 10B, in some examples, the diameter of the opening of the second insulation layer 32 and the diameter of the opening of the first insulation layer 31 are equal to each other, that is, both are equal to L5, so that the opening of the first insulation layer 31 and the opening of the second insulation layer 32 can be prepared by using the same mask, thereby reducing the amount of required masks, and reducing the production cost. For example, in other examples, the diameter of the opening of the second insulation layer 32 may be larger than the diameter of the opening of the first insulation layer 31, so that the sixth hole H6 can be formed into a three-step shape, so as to further reduce the processing difficulty, and facilitate the deposition of the conductive material (e.g., the material of the anode 4311) in the sixth hole H6, so as to further improve the reliability of electrical connection.

For example, the anode 4311 of the third light-emitting element 431 includes a fourth groove structure GR4, the fourth groove structure GR4 is located in the sixth hole H6, and the bottom of the fourth groove structure GR4 is in contact with the first electrode 4323 or the second electrode 4324 of the third switch transistor (e.g., switch thin film transistor 432T) for realizing electrical connection. By setting the portion, which is deposited in the sixth hole H6, of the anode 4311 into a groove structure, the thickness of this portion can be reduced, the thickness of this portion is not much different from the thickness of other portions of the anode 4311, so as to improve the uniformity of the transmitted light as a whole. Because the sixth hole H6 is in the shape of an inverted convex, when the anode 4311 is prepared, it is beneficial to form the groove structure, which can reduce the processing difficulty. For example, the surface of the fourth groove structure GR4 away from the source-drain metal layer SD may be a curved surface, a flat surface, an inclined surface, etc., and the embodiments of the present disclosure are not limited thereto.

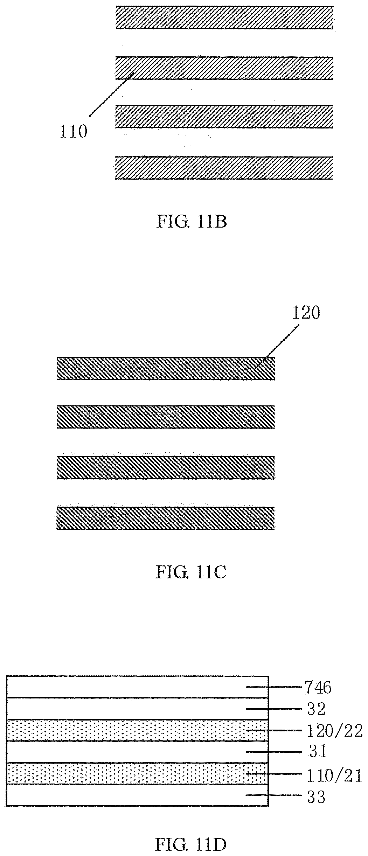

FIG. 11A is a schematic layout diagram corresponding to a partial region REG4 in FIG. 4; FIG. 11B is a schematic layout diagram illustrating only a first connection line in FIG. 11A; FIG. 11C is a schematic layout diagram illustrating only a second connection line in FIG. 11A; and FIG. 11D is a schematic view of a cross section along a line E-E' in FIG. 11A. For example, as illustrated in FIG. 11A to FIG. 11C, in the first display region 11, in the region where the anode is not provided, the first connection line 110 and the second connection line 120 extend along respective extension directions, respectively, for example, the extension direction of the first connection line 110 and the extension direction of the second connection line 120 may be the same or different. It should be noted that although the projection of the first connection line 110 and the projection of the second connection line 120 in FIG. 11A overlap, because the first connection line 110 and the second connection line 120 are located in different film layers, the first connection line 110 and the second connection line 120 are still insulated from each other, and the signal transmission of the first connection line 110 and the signal transmission of the second connection line 120 are not affected. For example, as illustrated in FIG. 11D, the third insulation layer 33, the first connection line 110 (i.e., the first connection layer 21), the first insulation layer 31, the second connection line 120 (i.e., the second connection layer 22), the second insulation layer 32, and the pixel defining layer 746 are stacked in sequence. Because the first insulation layer 31 is provided, the first connection line 110 and the second connection line 120 are insulated from each other and are not shortcircuited. For the other film layers, reference can be made to the foregoing content, and the other film layers are not illustrated in FIG. 11D.

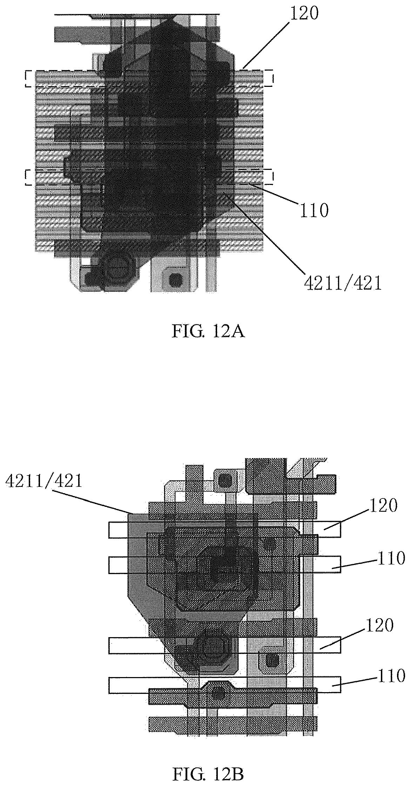

FIG. 12A is a first schematic layout diagram corresponding to a second light-emitting element in a second display region of a display substrate provided by some embodiments of the present disclosure; and FIG. 12B is a second schematic layout diagram corresponding to a second light-emitting element in a second display region of a display substrate provided by some embodiments of the present disclosure. For example, as illustrated in FIG. 12A to FIG. 12B, in the second display region 12, in the region where the second light-emitting element 421 is provided, the first connection line 110 and the second connection line 120 pass under the anode 4211 of the second light-emitting element 421 (that is, the side of the anode 4211 close to the base substrate 74) and are insulated from the anode 4211 of the second light-emitting element 421.

For example, in the embodiments of the present disclosure, each of the first connection line 110 and the second connection line 120 may include a transparent conductive wiring, and the transparent conductive wiring is made of, for example, indium tin oxide (ITO). Setting the first connection line 110 and the second connection line 120 as transparent conductive wiring can improve the light transmittance of the display substrate 01.

For example, the plurality of first light-emitting elements 411 are arranged in an array, and both the first connection line 110 and the second connection line 120 extend along the row direction of the array formed by the plurality of first light-emitting elements 411. Of course, the embodiments of the present disclosure are not limited thereto, and the extension directions of the first connection line 110 and the second connection line 120 may also be any other directions, and are not limited by the embodiments of the present disclosure. For example, the extension direction of the first connection line 110 and the extension direction of the second connection line 120 may be the same or different.

For example, each of the first light-emitting element 411, the second light-emitting element 421, and the third light-emitting element 431 may include an organic light-emitting diode (OLED), respectively. Of course, the embodiments of the present disclosure are not limited thereto, the first light-emitting element 411, the second light-emitting element 421, and the third light-emitting element 431 may also be quantum dot light-emitting diodes (QLEDs) or other suitable light-emitting devices, and the embodiments of the present disclosure do not limit this.

For example, a distribution density per unit area of the plurality of first light-emitting elements 411 in the first display region 11 is smaller than a distribution density per unit area of the plurality of second light-emitting elements 421 in the second display region 12, and the distribution density per unit area of the plurality of second light-emitting elements 421 in the second display region 12 is smaller than a distribution density per unit area of the plurality of third light-emitting elements 431 in the third display region 13. For example, the first display region 11 and the second display region 12 may be referred to as a low-resolution region of the display substrate 01, and correspondingly, the third display region 13 may be referred to as a high-resolution region of the display substrate 01. For example, the sum of the pixel light-emitting area of the second display region 12 and the pixel light-emitting area of the first display region 11 may be 1/8 to 1/2 of the pixel light-emitting area of the third display region 13.

It should be noted that, in some examples, the distribution density per unit area of the plurality of first light-emitting elements 411 in the first display region 11 may also be equal to the distribution density per unit area of the plurality of second light-emitting elements 421 in the second display region 12, this can be determined according to actual requirements, and the embodiments of the present disclosure do not limit this.

By sequentially increasing the distribution density per unit area of the light-emitting elements in the first display region 11, the distribution density per unit area of the light-emitting elements in the second display region 12, and the distribution density per unit area of the light-emitting elements in the third display region 13, it can be ensured that when the three display regions emit light normally to display images, it is convenient for the light from the first side of the display substrate 01 to pass through the first display region 11 to reach the second side, so as to facilitate the sensor disposed on the second side of the display substrate 01 to sense the light.

It should be noted that, in the embodiments of the present disclosure, the display substrate 01 may further include other structures or components, and is not limited to the structures and components described above. For example, the display substrate 01 may further include one or more barrier layers, buffer layers, etc., and the embodiments of the present disclosure are not limited thereto.

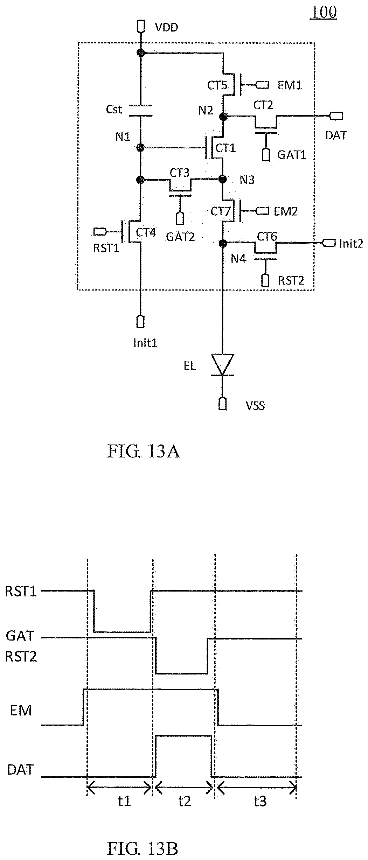

FIG. 13A is a schematic structural diagram of a 7T1C pixel circuit. For example, the aforementioned first pixel circuit 412 (e.g., the first pixel sub-circuit 412a and the second pixel sub-circuit 412b), the second pixel circuit 422, and the third pixel circuit 432 can all adopt the 7T1C pixel circuit.

For example, as illustrated in FIG. 13A, the 7T1C pixel circuit 100 includes a first transistor CT1, a second transistor CT2, a third transistor CT3, a fourth transistor CT4, a fifth transistor CT5, a sixth transistor CT6, a seventh transistor CT7, and a storage capacitor Cst. For example, the first to seventh transistors CT1 to CT7 are all P-type transistors.

As illustrated in FIG. 13A, a first end of the storage capacitor Cst is connected to a first power voltage terminal VDD to receive a first power voltage VI, and a second end of the storage capacitor Cst is connected to a first node N1. A first end of the light-emitting element EL is connected to a fourth node N4, and a second end of the light-emitting element EL is connected to a second power voltage terminal VSS to receive a second power voltage V2. A control end of the first transistor CT1 is connected to the first node N1, a first end of the first transistor CT1 is connected to a second node N2, and a second end of the first transistor CT1 is connected to a third node N3. A first end of the second transistor CT2 is connected to the second node N2, and a second end of the second transistor CT2 is connected to a data signal terminal DAT to receive a data signal (e.g., a data voltage) Vdata. A first end of the third transistor CT3 is connected to the first node N1, and a second end of the third transistor CT3 is connected to the third node N3.

A first end of the fourth transistor CT4 is connected to the first node N1, and a second end of the fourth transistor CT4 is connected to a first reset signal terminal Init1 to receive a first reset signal Vinit1 provided by the first reset signal terminal Init1. A first end of the fifth transistor CT5 is connected to the first power voltage terminal VDD, and a second end of the fifth transistor CT5 is connected to the second node N2. A first end of the sixth transistor CT6 is connected to the fourth node N4, and a second end of the sixth transistor CT6 is connected to a second reset signal terminal Init2 to receive a second reset signal Vinit2. A first end of the seventh transistor CT7 is connected to the third node N3, and a second end of the seventh transistor CT7 is connected to the fourth node N4.

For example, a control end GAT1 of the second transistor CT2 and a control end GAT2 of the third transistor CT3 are both connected to a scan signal terminal GAT (not illustrated in the figure), a control end EM1 of the fifth transistor CT5 and a control end EM2 of the seventh transistor CT7 are both connected to a light-emitting control terminal EM (not illustrated in the figure), a control end of the fourth transistor CT4 is configured to be connected to the first reset control terminal RST1, and a control end of the sixth transistor CT6 is configured to be connected to the second reset control terminal RST2. For the convenience of description, FIG. 13A also illustrates the first node N1, the second node N2, the third node N3, the fourth node N4, and the light-emitting element EL.

FIG. 13B is a driving timing diagram of the 7T1C pixel circuit illustrated in FIG. 13A. As illustrated in FIG. 13B, each driving cycle of the 7T1C pixel circuit 100 includes a first phase t1, a second phase t2, and a third phase t3.

As illustrated in FIG. 13A and FIG. 13B, in the first phase t1, the first reset control terminal RST1 receives an active level, and the scan signal terminal GAT, the second reset control terminal RST2, and the light-emitting control terminal EM all receive an invalid level. In this case, the fourth transistor CT4 is turned on, and the second transistor CT2, the third transistor CT3, the fifth transistor CT5, the sixth transistor CT6, and the seventh transistor CT7 are turned off; the fourth transistor CT4 is configured to receive a first reset signal (e.g., reset voltage) Vinit1, and write the first reset signal Vinit1 to the storage capacitor Cst to reset the storage capacitor Cst; the voltage of the first node N1 is Vinit1, and Vinit1 is, for example, a negative value. For example, after resetting the storage capacitor Cst, the first transistor CT1 is turned on.

As illustrated in FIG. 13A and FIG. 13B, in the second phase t2, the scan signal terminal GAT and the second reset control terminal RST2 receive an active level, and the first reset control terminal RST1 and the light-emitting control terminal EM receive an invalid level; in this case, the first transistor CT1 to the third transistor CT3 and the sixth transistor CT6 are turned on, and the fourth transistor CT4, the fifth transistor CT5, and the seventh transistor CT7 are turned off; the second transistor CT2 receives the data signal Vdata, and the data signal Vdata is written to the control end of the first transistor CT1 through the turned-on first transistor CT1 and the turned-on third transistor CT3, the storage capacitor Cst stores the data signal Vdata written into the control end of the first transistor CT1 at the control end of the first transistor CT1, and the voltage of the first node N1 is Vdata+Vth; the sixth transistor CT6 is configured to receive the second reset signal (e.g., reset voltage) Vinit2, and write the second reset signal Vinit2 to the first end of the light-emitting element EL to reset the first end of the light-emitting element EL, and the voltage of the fourth node N4 is Vinit2, and Vinit2 is, for example, a negative value.

As illustrated in FIG. 13A and FIG. 13B, in the third phase t3, the light-emitting control terminal EM receives an active level, and the first reset control terminal RST1, the scan signal terminal GAT, and the second reset control terminal RST2 receive an invalid level; in this case, the first transistor CT1, the fifth transistor CT5, and the seventh transistor CT7 are turned on, and the second transistor CT2, the third transistor CT3, the fourth transistor CT4, and the sixth transistor CT6 are turned off; the first transistor CT1 is configured to, based on the data signal (e.g., data voltage) Vdata stored in the storage capacitor Cst and the received first power voltage VI, control a driving current flowing through the first transistor CT1 and from the first power voltage terminal VDD to the light-emitting element EL for driving the light-emitting element EL; the voltage of the first node N1 is Vdata+Vth, and the voltage of the second node N2 is VDD; the driving current Id can be represented by the following formula:

$$
\begin{aligned}
\mathrm{Id} &= \frac{k}{2}(Vgs\text{-}Vth)^2 \\
&= \frac{k}{2}(Vg - Vs\text{-}Vth)^2 \\
&= \frac{k}{2}(Vdata + Vth - V1\text{-}Vth)^2 \\
&= \frac{k}{2}(Vdata - V1)^2
\end{aligned}
$$

Here, $k = \mu \times Cox \times W/L$; $\mu$ is the mobility of carriers in the first transistor CT1, Cox is the capacitance of the gate oxide layer of the first transistor CT1, and W/L is the width to length ratio of the channel of the first transistor CT1, Vth is the threshold voltage of the first transistor CT1, Vgs is the gate-source voltage of the first transistor CT1, Vg is the gate voltage of the first transistor CT1, and Vs is the source voltage of the first transistor CT1.

It can be seen from the above formula that the driving current Id generated by the first transistor CT1 has nothing to do with the threshold voltage of the first transistor CT1. Therefore, the 7T1C pixel circuit 100 illustrated in FIG. 13A and FIG. 13B has a threshold compensation function.

It should be noted that, in the embodiments of the present disclosure, the first pixel circuit 412 (for example, the first pixel sub-circuit 412a and the second pixel sub-circuit 412b), the second pixel circuit 422, and the third pixel circuit 432 are not limited to the above-mentioned 7T1C pixel circuit, may also adopt other applicable pixel circuits, and the embodiments of the present disclosure are not limited in this regard. The specific circuit structure of the first pixel circuit 412, the specific circuit structure of the second pixel circuit 422, and the specific circuit structure of the third pixel circuit 432 may be the same or different from each other, which may be determined according to actual requirements, and the embodiments of the present disclosure do not limit this.

For example, the first switch transistor in the first pixel circuit 412, the second switch transistor in the second pixel circuit 422, and the third switch transistor in the third pixel circuit 432 all may be the seventh transistor CT7 in FIG. 13A, and the seventh transistor CT7 supplies an electrical signal to the anode of the corresponding light-emitting element EL. For example, the first light-emitting element 411 (e.g., the first light-emitting sub-element 411a and the second light-emitting sub-element 411b), the second light-emitting element 421, and the third light-emitting element 431 all may be the light-emitting element EL in FIG. 13A, the light-emitting element EL may be an organic light-emitting diode (OLED) or a quantum dot light-emitting diode (QLED).

At least one embodiment of the present disclosure further provides a display device, and the display device comprises the display substrate provided by any embodiment of the present disclosure. The display device can reduce the processing difficulty, improve the reliability of the electrical connection, improve the uniformity of transmitted light, and help to improve the sensing effect of the under-screen sensor (such as a camera).

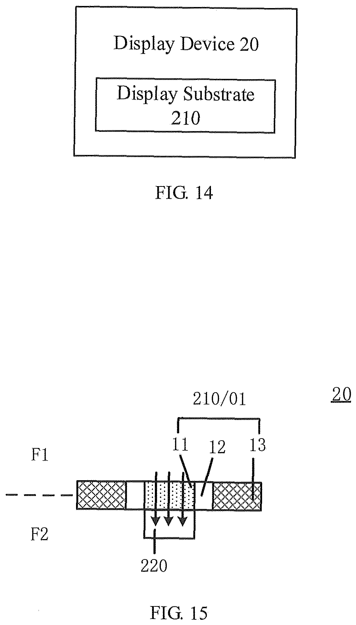

FIG. 14 is a schematic block diagram of a display device provided by at least one embodiment of the present disclosure. For example, as illustrated in FIG. 14, the display device 20 includes a display substrate 210, and the display substrate 210 is the display substrate provided by any embodiment of the present disclosure, such as the aforementioned display substrate 01. The display device 20 can be any electronic device having a display function, such as a smartphone, a notebook computer, a tablet computer, a TV, and the like. For example, when the display device 20 is a smartphone or a tablet computer, the smartphone or the tablet computer may have a full-screen design, that is, does not have a peripheral region surrounding the third display region 13. In addition, the smartphone or the tablet computer also has an under-screen sensor (such as a camera, an infrared sensor, etc.), which can perform operations such as image shooting, distance sensing, light intensity sensing, and the like.

It should be noted that applicable components may be used for the other components (e.g., image data encoding/decoding device, clock circuit, etc.) of the display substrate 210 and the display device 20, which should be understood by those of ordinary skill in the art, and will not be repeated here, nor should they be used as limitations to the embodiments of the present disclosure.

FIG. 15 is a schematic diagram of a stacked structure of a display device provided by at least one embodiment of the present disclosure. For example, as illustrated in FIG. 15, the display device 20 includes a display substrate 210, and the display substrate 210 is the display substrate provided by any embodiment of the present disclosure, such as the aforementioned display substrate 01. For example, the display device 20 further includes a sensor 220.

For example, the display substrate 01 has a first side F1 for display and a second side F2 opposite to the first side F1. That is, the first side F1 is the display side, and the second side F2 is the non-display side. The display substrate 01 is configured to perform a display operation on the first side F1, that is, the first side F1 of the display substrate 01 is the light-emitting side of the display substrate 01, and the first side F1 faces the user. The first side F1 and the second side F2 are opposite to each other in the normal direction of the display surface of the display substrate 01.

As illustrated in FIG. 15, the sensor 220 is disposed on the second side F2 of the display substrate 01, and the sensor 220 is configured to receive light from the first side F1. For example, the sensor 220 is overlapped with the first display region 11 in the normal direction (e.g., a direction perpendicular to the display substrate 01) of the display surface of the display substrate 01, the sensor 220 may receive and process a light signal passing through the first display region 11, and the light signal may be visible light, infrared light, or the like. For example, the first display region 11 allows light from the first side F1 to be at least partially transmitted to the second side F2. For example, the first display region 11 is not provided with a pixel circuit. In this case, the light transmittance of the first display region 11 can be improved.

For example, the orthographic projection of the sensor 220 on the display substrate 01 at least partially overlaps the first display region 11. For example, in some examples, the orthographic projection of the sensor 220 on the display substrate 01 is located in the first display region 11 when the direct type setting mode is adopted. For example, in other examples, when other light guide elements (such as a light guide plate, a light guide tube, etc.) are used to make the light incident on the sensor 220 from the side, the orthographic projection of the sensor 220 on the display substrate 01 partially overlaps the first display region 11. In this case, because the light can be laterally propagated to the sensor 220, the sensor 220 does not need to be completely located at the position corresponding to the first display region 11.

For example, by disposing the first pixel circuit 412 in the second display region 12 and overlapping the sensor 220 with the first display region 11 in the normal direction of the display surface of the display substrate 01, the shielding of the elements in the first display region 11 to the light signal incident on the first display region 11 and irradiated to the sensor 220 can be reduced, thereby improving the signal-to-noise ratio of the image output by the sensor 220. For example, the first display region 11 may be referred to as a high light transmission region of a low-resolution region of the display substrate 01, and the second display region 12 may be referred to as a transition region.

For example, the sensor 220 may be an image sensor, which may be used to acquire an image of the external environment facing the light collecting surface of the sensor 220, for example, the sensor 220 may be a CMOS image sensor or a CCD image sensor. The sensor 220 may also be an infrared sensor, a distance sensor, or the like. For example, in the case where the display device 20 is a mobile terminal such as a mobile phone, a notebook, etc., the sensor 220 can be implemented as a camera of the mobile terminal such as a mobile phone, a notebook, etc., and can also include optical devices such as a lens, a reflector, or an optical waveguide as required to modulate the optical path. For example, the sensor 220 may include photosensitive pixels arranged in an array. For example, each photosensitive pixel may include a photodetector (e.g., photodiode, phototransistor) and a switch transistor (e.g., switch thin film transistor). For example, the photodiode can convert an optical signal irradiated thereon into an electrical signal, and the switch transistor can be electrically connected to the photodiode to control whether the photodiode is in the state of collecting the optical signal and the time for collecting the optical signals.

In some examples, the anode of the first light-emitting element 411 adopts a laminated structure of ITO/Ag/ITO, then in the first display region 11, only the anode of the first light-emitting element 411 is opaque to light, that is, the wiring (e.g., the first connection line 110 and the second connection line 120) for driving the first light-emitting element 411 is set as transparent conductive wiring. In this case, not only the light transmittance of the first display region 11 can be further improved, but also the diffraction and reflection caused by various elements in the first display region 11 can be reduced.

It should be noted that, in the embodiments of the present disclosure, the display device 20 may further include more components and structures, which are not limited in the embodiments of the present disclosure. For the technical effect and detailed description of the display device 20, reference may be made to the above description of the display substrate 01, and similar parts will not be repeated here.

The following several statements should be noted.

(1) The accompanying drawings involve only the structure(s) in connection with the embodiment(s) of the present disclosure, and other structure(s) can be referred to common design(s).
(2) In case of no conflict, embodiments of the present disclosure and the features in the embodiments may be mutually combined to obtain new embodiments.

What have been described above are only specific implementations of the present disclosure, the protection scope of the present disclosure is not limited thereto. The protection scope of the present disclosure should be based on the protection scope of the claims.

## Claims

**1.** A display substrate, comprising a display region,

wherein the display region comprises a first display region and a second display region that do not overlap with each other, the second display region at least partially surrounds the first display region, and light transmittance of the first display region is greater than light transmittance of the second display region;
the first display region comprises at least one first light-emitting element, and the second display region comprises at least one first pixel circuit;
the display region further comprises at least one first connection line, and the first connection line comprises a first end located in the first display region and a second end located in the second display region;
the at least one first light-emitting element comprises a first light-emitting sub-element, and the at least one first pixel circuit comprises a first pixel sub-circuit, the first end of the first connection line is electrically connected to an anode of the first light-emitting sub-element, and the second end of the first connection line is electrically connected to the first pixel sub-circuit;
the display substrate comprises a first connection layer, a first insulation layer, a second insulation layer, and an anode layer that are stacked in sequence;
the first connection line is in the first connection layer, the anode of the first light-emitting sub-element is in the anode layer, and the anode of the first light-emitting sub-element is electrically connected to the first connection line through a first hole penetrating the first insulation layer and the second insulation layer;
a shape of a cross section of the first hole in a plane perpendicular to the display substrate is an inverted convex shape, and in the first hole, a diameter of an opening of the second insulation layer is larger than a diameter of an opening of the first insulation layer; and
the anode of the first light-emitting sub-element comprises a first groove structure, the first groove structure is in the first hole, and a bottom of the first groove structure is in contact with the first connection line for realizing electrical connection.

**2.** The display substrate according to claim 1, wherein the display region further comprises at least one second connection line, and the second connection line comprises a first end located in the first display region and a second end located in the second display region;

the at least one first light-emitting element further comprises a second light-emitting sub-element, the at least one first pixel circuit further comprises a second pixel sub-circuit, the first end of the second connection line is electrically connected to an anode of the second light-emitting sub-element, and the second end of the second connection line is electrically connected to the second pixel sub-circuit;
the display substrate further comprises a second connection layer, the second connection layer is between the first insulation layer and the second insulation layer, and the second connection line is in the second connection layer;
the anode of the second light-emitting sub-element is in the anode layer, and the anode of the second light-emitting sub-element is electrically connected to the second connection line through a second hole penetrating the second insulation layer; and

the anode of the second light-emitting sub-element comprises a second groove structure, the second groove structure is in the second hole, and a bottom of the second groove structure is in contact with the second connection line for realizing electrical connection.

3. The display substrate according to claim 2, wherein a surface of the first groove structure away from the first connection layer is a curved surface, and a surface of the second groove structure away from the second connection layer is a curved surface.

4. The display substrate according to claim 2 or 3, wherein each of the first pixel sub-circuit and the second pixel sub-circuit comprises a first switch transistor, and the first switch transistor comprises a gate electrode, a first electrode, and a second electrode;

the display substrate further comprises a source-drain metal layer and a third insulation layer, the third insulation layer is on the source-drain metal layer, the first connection layer is on the third insulation layer, and the first electrode of the first switch transistor and the second electrode of the first switch transistor are in the source-drain metal layer;

the second end of the first connection line is electrically connected to the first electrode or the second electrode of the first switch transistor of the first pixel sub-circuit through a third hole penetrating the third insulation layer; and

the second end of the second connection line is electrically connected to the first electrode or the second electrode of the first switch transistor of the second pixel sub-circuit through a fourth hole penetrating the third insulation layer and the first insulation layer.

5. The display substrate according to claim 4, wherein a shape of a cross section of the fourth hole in the plane perpendicular to the display substrate is an inverted convex shape, and in the fourth hole, a diameter of an opening of the first insulation layer is larger than a diameter of an opening of the third insulation layer.

6. The display substrate according to claim 4 or 5, wherein, in the fourth hole, the second connection line is electrically connected to a transition metal layer, the transition metal layer is in contact with and is electrically connected to the first electrode or the second electrode of the first switch transistor of the second pixel sub-circuit, and the transition metal layer and the first connection layer are formed in a same process.

7. The display substrate according to any one of claims 4-6, wherein the second display region further comprises at least one second light-emitting element and at least one second pixel circuit, and the second light-emitting element is electrically connected to the second pixel circuit;

the second pixel circuit comprises a second switch transistor, the second switch transistor comprises a gate electrode, a first electrode, and a second electrode, and the first electrode of the second switch transistor and the second electrode of the second switch transistor are in the source-drain metal layer;

an anode of the second light-emitting element is in the anode layer, and the anode of the second light-emitting element is electrically connected to the first electrode or the second electrode of the second switch transistor through a fifth hole penetrating the first insulation layer, the second insulation layer, and the third insulation layer; and

a shape of a cross section of the fifth hole in the plane perpendicular to the display substrate is an inverted convex shape, and in the fifth hole, a diameter of an opening of the first insulation layer is larger than a diameter of an opening of the third insulation layer.

8. The display substrate according to claim 7, wherein, in the fifth hole, a diameter of an opening of the second insulation layer is equal to or larger than the diameter of the opening of the first insulation layer.

9. The display substrate according to claim 7 or 8, wherein the anode of the second light-emitting element comprises a third groove structure, the third groove structure is in the fifth hole, and a bottom of the third groove structure is in contact with the first electrode or the second electrode of the second switch transistor for realizing electrical connection.

10. The display substrate according to any one of claims 7-9, wherein the display region further comprises a third display region, the third display region at least partially surrounds the second display region, and the third display region does not overlap with the first display region and the second display region;

the third display region comprises at least one third light-emitting element and at least one third pixel circuit, and the third light-emitting element is electrically connected to the third pixel circuit; the third pixel circuit comprises a third switch transistor, the third switch transistor comprises a gate electrode, a first electrode, and a second electrode, and the first electrode of the third switch transistor and the second electrode of the third switch transistor are in the source-drain metal layer;

an anode of the third light-emitting element is in the anode layer, and the anode of the third light-emitting element is electrically connected to the first electrode or the second electrode of the third switch transistor through a sixth hole penetrating the first insulation layer, the second insulation layer, and the third insulation layer; and

a shape of a cross section of the sixth hole in the plane perpendicular to the display substrate is an inverted convex shape, and in the sixth hole, a diameter of an opening of the first insulation layer is larger than a diameter of an opening of the third insulation layer.

11. The display substrate according to claim 10, wherein, in the sixth hole, a diameter of an opening of the second insulation layer is equal to or larger than the diameter of the opening of the first insulation layer.

12. The display substrate according to claim 10 or 11, wherein the anode of the third light-emitting element comprises a fourth groove structure, the fourth groove structure is in the sixth hole, and a bottom of the fourth groove structure is in contact with the first electrode or the second electrode of the third switch transistor for realizing electrical connection.

13. The display substrate according to any one of claims 2-12, wherein the first connection line and the second connection line each comprises a transparent conductive wiring.

14. The display substrate according to any one of claims 2-12, wherein the at least one first light-emitting element comprises a plurality of first light-emitting elements, the plurality of first light-emitting elements are arranged in an array, and both the first connection line and the second connection line extend along a row direction of the array formed by the plurality of first light-emitting elements.

15. The display substrate according to any one of claims 10-12, wherein each of the first light-emitting element, the second light-emitting element, and the third light-emitting element comprises an organic light-emitting diode.

16. The display substrate according to any one of claims 10-12, wherein the at least one first light-emitting element comprises a plurality of first light-emitting elements, the at least one second light-emitting element comprises a plurality of second light-emitting elements, and the at least one third light-emitting element comprises a plurality of third light-emitting elements; and

a distribution density per unit area of the plurality of first light-emitting elements in the first display region is smaller than or equal to a distribution density per unit area of the plurality of second light-emitting elements in the second display region, and the distribution density per unit area of the plurality of second light-emitting elements in the second display region is smaller than a distribution density per unit area of the plurality of third light-emitting elements in the third display region.

17. A display device, comprising the display substrate according to any one of claims 1-16.

18. The display device according to claim 17, further comprising a sensor,

wherein the display substrate has a first side for display and a second side opposite to the first side, and the first display region allows light from the first side to be at least partially transmitted to the second side,

the sensor is on the second side of the display substrate, and the sensor is configured to receive light from the first side.

19. The display device according to claim 17 or 18, wherein an orthographic projection of the sensor on the display substrate at least partially overlaps the first display region.

01

10

12  11  13

REG3

FIG. 1

11  12

FIG. 2

REG2  REG1  12

11

FIG. 3

FIG. 4

FIG. 5A

FIG. 5B

FIG. 6A

GR1

746
4111
32
31
110/21
33

H1

FIG. 6B

H1          110
31,32

746
4111/411a

120

FIG. 6C

4124/SD

H3          110

FIG. 6D

12 ⟷ 11

01

H4  GR2  H2

747

4113 ⎫
4112 ⎬ 411b
4111/40 ⎭

746

32

31

33

743

742

741

74

78

4125  4126
412C/412b

4123/SD  4121  4122  4124/SD
412T/412b

120/22

FIG. 7A

GR2

H2

746

4111

32

120/22

31

33

FIG. 7B

H2

120

32

4111/411b

746

110

FIG. 7C

H4

120

23

746
32
31
33
4124/SD
743

FIG. 7D

120

H4

4124/SD

FIG. 7E

FIG. 8A

GR3  H5

01

747
746
32
31
33
743
742
741
74

4213
4212
4211/40
421

78

4225  4226
422C/422

4223/SD  4221  4222  4224/SD
422T/422

EP 4 068 384 A1

30

FIG. 8B

FIG. 8C

FIG. 9

FIG. 10A

GR4　　　H6

746

4311

32

31

L5

33

L6

4324/SD

743

FIG. 10B

120

110

E　　　　　E'

FIG. 11A

110

FIG. 11B

120

FIG. 11C

| | 746 |
| | 32 |
| | 120/22 |
| | 31 |
| | 110/21 |
| | 33 |

FIG. 11D

FIG. 12A

FIG. 12B

FIG. 13A

FIG. 13B

Display Device 20

Display Substrate
210

FIG. 14

210/01                    20

11   12   13

F1

F2

220

FIG. 15

## INTERNATIONAL SEARCH REPORT

| International application No. |
|---|
| **PCT/CN2021/094030** |

**A. CLASSIFICATION OF SUBJECT MATTER**

H01L 27/32(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNPAT, EPODOC, WPI, CNKI: 显示, 区, 基板, 透光率, 发光, 晶体管, 像素, 孔, 电路, 走线, 连接, 阳极, 厚度, 均匀, display, area, plate, transmittance, panel, light, OLED, TFT, pixel?, wire, connect+, anode, thick, uniform

**C. DOCUMENTS CONSIDERED TO BE RELEVANT**

| Category* | Citation of document, with indication, where appropriate, of the relevant passages | Relevant to claim No. |
|---|---|---|
| A | CN 110189639 A (KUNSHAN GOVISIONOX OPTOELECTRONICS CO., LTD.) 30 August 2019 (2019-08-30) description, paragraphs [0068]-[0099], and figures 1-10 | 1-19 |
| A | CN 110767141 A (KUNSHAN GOVISIONOX OPTOELECTRONICS CO., LTD.) 07 February 2020 (2020-02-07) entire document | 1-19 |
| A | CN 111028765 A (WUHAN TIANMA MICROELECTRONICS CO., LTD.) 17 April 2020 (2020-04-17) entire document | 1-19 |
| A | CN 110767729 A (GUANGDONG OPPO MOBILE TELECOMMUNICATIONS CORP., LTD.) 07 February 2020 (2020-02-07) entire document | 1-19 |
| A | CN 111211152 A (KUNSHAN GOVISIONOX OPTOELECTRONICS CO., LTD.) 29 May 2020 (2020-05-29) entire document | 1-19 |
| A | US 2014042396 A1 (LG DISPLAY CO., LTD.) 13 February 2014 (2014-02-13) entire document | 1-19 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 August 2021** | **16 August 2021** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2021/094030**

| Patent document cited in search report | | | Publication date (day/month/year) | Patent family member(s) | | | Publication date (day/month/year) |
|---|---|---|---|---|---|---|---|
| CN | 110189639 | A | 30 August 2019 | TW | 202025116 | A | 01 July 2020 |
| | | | | CN | 110189639 | B | 04 December 2020 |
| | | | | WO | 2020258862 | A1 | 30 December 2020 |
| CN | 110767141 | A | 07 February 2020 | None | | | |
| CN | 111028765 | A | 17 April 2020 | None | | | |
| CN | 110767729 | A | 07 February 2020 | None | | | |
| CN | 111211152 | A | 29 May 2020 | None | | | |
| US | 2014042396 | A1 | 13 February 2014 | CN | 103579283 | B | 28 December 2016 |
| | | | | CN | 103579283 | A | 12 February 2014 |
| | | | | KR | 20140019990 | A | 18 February 2014 |
| | | | | KR | 101480928 | B1 | 09 January 2015 |
| | | | | US | 9093660 | B2 | 28 July 2015 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010580274